# EUROPEAN PATENT SPECIFICATION

(11) **EP 4 490 474 B1**
(45) Date of publication and mention of the grant of the patent: **10.12.2025**
(21) Application number: 23709137.6
(22) Date of filing: 28.02.2023
(51) Int. Cl.: G01G 19/00, G01G 23/00, H01L 21/67, H01L 21/66, H01L 21/677, H01L 21/687

(54) **WEIGHING DEVICE FOR A SEMICONDUCTOR WAFER**
WÄGEVORRICHTUNG FÜR EINE HALBLEITERSCHEIBE
DISPOSITIF DE PESAGE POUR TRANCHE DE SEMI-CONDUCTEUR

(30) Priority: 07.03.2022 GB 202203108
(43) Date of publication of application: 15.01.2025
(73) Proprietor: Metryx Ltd., Bristol BS32 4SH (GB)
(72) Inventor: ELLIOTT, Gregor Robert, Bristol BS32 4SH (GB); WILBY, Robert John, Bristol BS32 4SH (GB); DUTTON, Huw, Bristol BS32 4SH (GB)
(74) Representative: Mewburn Ellis LLP
(86) International application number: PCT/EP2023/055023
(87) International publication number: WO 2023/169880

(56) References cited:
- WO-A2-02/03449
- CN-A- 112 410 764
- KR-A- 20220 136 647

## Description

### Field of the invention

The present invention relates to a weighing device for performing a weight measurement on a wafer.

### Background of the invention

Microelectronic devices are fabricated on semiconductor (e.g. silicon) wafers using a variety of techniques, e.g. including deposition techniques (CVD, PECVD, PVD, etc.) and removal techniques (e.g. chemical etching, CMP, etc.). Semiconductor wafers may be further treated in ways that alter their mass, e.g. by cleaning, ion implantation, lithography and the like.

Depending on the device being manufactured, each semiconductor wafer may be passed sequentially through hundreds of different processing steps to build up and/or to remove the layers and materials necessary for its ultimate operation. In effect, each semiconductor wafer is passed down a production line. The nature of semiconductor manufacturing means that certain processing steps or sequences of steps in the production flow may be repeated in a similar or identical fashion. For example, this may be to build up similar layers of metal conductors to interconnect different parts of the active circuitry.

To ensure consistency and interoperability of semiconductor equipment used in different factories, standards are adopted throughout the majority of the semiconductor manufacturing industry. For example, standards developed by Semiconductor Equipment and Materials International (SEMI) have a high degree of market uptake. One example of standardisation is the size and shape of the semiconductor (silicon) wafers: typically for volume production they are discs having a diameter of 300 mm. However, some semiconductor (silicon) wafers (typically used in older factories) are discs having a diameter of 200 mm.

The cost and complexity of the processing steps required to produce a completed silicon wafer together with the time that it takes to reach the end of the production line where its operation can be properly assessed has led to a desire to monitor the operation of the equipment on the production line and the quality of the wafers being processed throughout processing, so that confidence in the performance and yield of the final wafers may be assured.

Wafer treatment techniques typically cause a change in mass at or on the surface of the semiconductor wafer. The configuration of the changes to the surface are often vital to the functioning of the device, so it is desirable for quality control purposes to assess wafers during production in order to determine whether they have the correct configuration.

Specialist metrology tools may be used within the production flow so that monitoring is conducted soon after the relevant process of interest and usually before any subsequent processing, i.e. between processing steps.

Measuring the change in mass of a wafer either side of a processing step is an attractive method for implementing product wafer metrology. It is relatively low cost, high speed and can accommodate different wafer circuitry patterns automatically. In addition, it can often provide results of higher accuracy than alternative techniques. For example, on many typical materials, thicknesses of material layers can be resolved down to an atomic scale. The wafer in question is weighed before and after the processing step of interest. The change in mass is correlated to the performance of the production equipment and/or the desired properties of the wafer.

More accurate measurement of the change in mass of a wafer allows for tighter quality control of the wafer processing.

WO/2002/003449 discloses an apparatus and method for investigating semiconductor wafers in which changes in the mass of the wafer are determined to assess various properties of the wafer, e.g. to enable fabrication of the wafer to be monitored. A common method of obtaining mass measurements is to use a very sensitive force sensor to measure the force (weight) due to gravity. At medium levels of accuracy this force can be assumed to be due solely to the mass of the wafer. However, if higher levels of accuracy are needed, other forces may need to be taken into account.

One such force disclosed in WO/2002/003449 is caused by atmospheric buoyancy. In semiconductor metrology, a semiconductor wafer is usually measured in an atmosphere (i.e. not a vacuum). The wafer therefore displaces a volume of this atmosphere, which causes an up thrust force. The up-thrust force depends on the atmospheric (air) density, which in turn depends on numerous factors including temperature, atmospheric pressure, relative humidity and air composition. The up-thrust force reduces the apparent weight of the wafer detected by the force sensor.

WO/2002/003449 discloses a method of compensating or correcting for the effect of atmospheric buoyancy. Sensors are provided to monitor temperature, pressure and relative humidity. A processor receives measurements from these sensors and uses them to calculate the air density, which can be used to compensate for buoyancy in a corresponding weight measurement. The processor can calculate buoyancy from the calculated air density, together with the weight measurement and density information about the wafer.

### Summary of the invention

The present inventors have realised that if a semiconductor wafer is not flat, for example the wafer has a curved or bowed shape, or if the wafer is not supported so that it is level or approximately level (e.g. horizontal or approximately horizontal) during a weight measurement, the weight measurement may be incorrect or inaccurate.

For example, if a semiconductor wafer is not supported so that it is level or approximately level (e.g. horizontal or approximately horizontal) during a weight measurement, there may be significant deviations between the position of the edge of the wafer that would be expected if the wafer was level and the actual position of the edge of the wafer.

In practice, it is not uncommon for a semiconductor wafer to be supported so that it is not level or approximately level during a weight measurement.

For example, the weight measurement may be performed using a load cell. When manufacturing such a load cell, a configuration and/or position and/or orientation of the load cell (and/or a housing enclosing the load cell) may be setup for optimal performance of the load cell. In this optimal setup the load cell (and/or a housing enclosing the load cell) is often not level. In other words, a weighing axis or weighing direction of the load cell (a direction along which the load cell measures a weight force) may not be vertical, and/or a top surface and/or a bottom surface of the load cell (and/or a housing enclosing the load cell) may not be horizontal.

If the load cell is not level, a balance pan or weighing pan that is connected or coupled to the load cell and that supports the semiconductor wafer during the weight measurement will also not be level, such that the wafer will not be supported so that it is level or approximately level (e.g. horizontal or approximately horizontal) during a weight measurement.

The deviation between the position of the edge of the wafer that would be expected if the wafer was level and the actual position of the edge of the wafer can cause a number of issues. For example, in some cases the deviation may be sufficient that the edge of the wafer comes into contact with a part of a device or apparatus, for example part of a measurement chamber enclosing a weighing device performing the weight measurement. This means that part of the weight of the wafer may be supported by the part of the device or apparatus, such that the weight measurement performed on the wafer is incorrect or inaccurate.

In addition, or alternatively, this deviation may change a spacing between part of the wafer, such as the edge of the wafer, and part of a device or apparatus, for example part of a measurement chamber enclosing a weighing device performing the weight measurement. In particular, the deviation may reduce a spacing between the part of the wafer and the part of the device or apparatus. This may increase an electrostatic force between the part of the wafer and the part of the device or apparatus, caused by electrostatic charge on the wafer and/or on the part of the device or apparatus. The electrostatic force acting on the wafer may change a weight force measured during the weight measurement, such that the weight measurement performed on the wafer is incorrect or inaccurate.

In addition, or alternatively, the load cell may be level, but a support (such as a balance pan or weighing pan) that is used to support the wafer during the weight measurement may not be level, for example due to variations in manufacture of the support. This may also lead to the wafer not being supported so that it is level or approximately level (e.g. horizontal or approximately horizontal) during a weight measurement.

In addition, or alternatively, to the problem discussed above, semiconductor wafers may not be flat. For example, a semiconductor wafer may have a curved or bowed shape.

This means that when the wafer is supported during a weight measurement, there may be uncertainty regarding the position of the edge of the wafer. There may therefore be significant deviations between the position of the edge of the wafer that would be expected if the wafer was flat and the actual position of the edge of the wafer. This deviation can also cause one or more of the issues discussed above.

Aspects of the present invention may address one or more of these problems.

According to a first aspect of the present invention there is provided a weighing device for performing a weight measurement on a wafer having a specific diameter D, the weighing device comprising a support for supporting the wafer during the weight measurement, wherein: the support comprises a plurality of contact elements configured to contact an underside of the wafer less than or equal to a distance of D/3 from an edge of the wafer, to support the wafer during the weight measurement.

According to the first aspect of the present invention, the wafer is supported from underneath closer to an edge (e.g. an outer circumferential edge or peripheral edge or radially outer edge) of the wafer than has been the case previously.

This means that even if the wafer is not flat (for example the wafer is curved or bowed), the position of the edge of the wafer may be better controlled and/or more clearly defined because the wafer is supported closer to the edge.

In contrast, if the wafer is supported closer to the centre of the wafer than in the present invention, and the wafer is curved or bowed, there may be significant uncertainty regarding the position of the edge of the wafer, which may lead to one of more of the problems discussed above.

The weighing device according to the first aspect of the present invention may have any one, or, where compatible, any combination of the following optional features.

The wafer may be a semiconductor wafer, for example a silicon wafer.

The wafer may have a disc shape.

Performing a weight measurement on the wafer may comprise performing a weight force measurement on the wafer.

Performing a weight measurement on the wafer may comprise generating a measurement output that is indicative of the weight of the wafer.

The measurement output may comprise an electrical signal or electrical output that corresponds to the weight being measured. For example, a magnitude of a current or a voltage of the electrical signal or electrical output may correspond to the weight being measured.

Performing a weight measurement on the wafer may comprise measuring a weight of the wafer, or measuring a difference between the weight of the wafer and the weight of another article, such as a reference mass or a reference wafer.

Performing a weight measurement on the wafer may comprise measuring a difference between the weight of the wafer and a counterweight.

The weighing device may be configured to calculate information relating to the mass of the wafer based on at least the weight measurement, such as the mass of the wafer or a change in the mass of the wafer.

The weighing device may comprise or be a microbalance.

The weighing device may comprise or be a weighing balance.

The weighing device may comprise or be an electronic balance.

The weighing device may comprise a force sensor or force transducer for generating measurement output indicative of the weight of an object loaded on the weighing device.

The weighing device may comprise a weight force sensor or weight force transducer for generating measurement output indicative of the weight of an object loaded on the weighing device.

The weighing device may comprise a load cell for generating measurement output indicative of the weight of an object loaded on the weighing device.

The weighing device may comprise an electromagnetic force compensation or electromagnetic force restoration force sensor or load cell.

The weighing device is for performing a weight measurement on a wafer having a specific diameter D. Specifically, the weighing device may be configured or adapted for performing the weight measurement on the wafer having the specific diameter D.

Typically, a semiconductor wafer processing or metrology apparatus is configured to handle a specific diameter of semiconductor wafer, such as 200mm or 300mm, and cannot be used with semiconductor wafers with other diameters. For example, typically it is impossible to upgrade an apparatus configured for 200mm diameter wafers to handle 300mm diameter wafers, and downgrading an apparatus configured to handle 300mm diameter wafers would typically require refitting the apparatus, for example by changing a wafer transport system, a weighing pan, and other elements.

The support may comprise or be a pan such as a balance pan or a weighing pan.

Supporting the wafer during the weight measurement means that the weight of the wafer is received by the support.

The support may alternatively be referred to as a measurement area onto which the wafer is loaded to perform the weight measurement.

The support may be connected or coupled to the force sensor, force transducer, weight force sensor, weight force transducer or load cell, so that a weight force of a wafer loaded on the support is transmitted from the support to the force sensor, force transducer, weight force sensor, weight force transducer or load cell.

The support comprises a plurality of contact elements configured to contact an underside of the wafer less than or equal to a distance of D/3 from an edge of the wafer.

The term contact element may mean a contact part or a contact member.

The term contact element may mean a wafer contact element, or a wafer contact part, or a wafer contact member.

The contact element may be a support element, or support part, or support member.

The distance may be a radial distance.

The distance may be measured along a plane of the wafer, and/or along the bottom or lower surface of the wafer.

The underside of the wafer may mean a bottom surface or side of the wafer, and/or a surface or side of the wafer that faces the weighing device during the weight measurement, and/or a lower surface or side of the wafer.

Each of the plurality of contact elements is configured to contact the underside of the wafer less than or equal to a distance of D/3 from the edge of the wafer.

Each of the plurality of contact elements is configured to contact the underside of the wafer at a respective position on the underside of the wafer that is less than or equal to a distance of D/3 from the edge of the wafer.

Each of the plurality of contact elements may be configured to contact the underside of the wafer at the same distance from the edge of the wafer. Alternatively, different contact elements may be configured to contact the underside of the wafer at different distances from the edge of the wafer.

The edge of the wafer may mean a circumferential edge, or circumference, or boundary, or periphery or radially outer edge of the underside of the wafer.

The weighing device may be configured or adapted to perform the weight measurement on the wafer having the specific diameter D.

The support may be configured or adapted to support the wafer during the weight measurement.

The weighing device may be for performing a weight measurement on a wafer having a 300 mm diameter. Therefore, the plurality of contact elements are configured to contact the underside of the wafer less than or equal to 100 mm from the edge of the wafer. The plurality of contact elements may be configured to contact the underside of the wafer less than or equal to 90 mm, or 80 mm, or 75 mm, or 70 mm, or 60 mm, or 50 mm, or 40 mm, or 30 mm, or 20 mm, or 10 mm from the edge of the wafer.

Alternatively, the weighing device may be for performing a weight measurement on a wafer having a 200 mm diameter. Therefore, the plurality of contact elements are configured to contact the underside of the wafer less than or equal to 67 mm from the edge of the wafer (to two significant figures). The plurality of contact elements may be configured to contact the underside of the wafer less than or equal to 60 mm, or 50 mm, or 40 mm, or 30 mm, or 20mm, or 10 mm from the edge of the wafer.

Alternatively, the weighing device may be for performing a weight measurement on a wafer having a 450 mm diameter. Therefore, the plurality of contact elements are configured to contact the underside of the wafer less than or equal to 150 mm from the edge of the wafer. The plurality of contact elements may be configured to contact the underside of the wafer less than or equal to 140 mm, or 130 mm, or 120 mm, or 112.5 mm, or 110 mm, or 100 mm, or 90 mm, or 80 mm, or 70 mm, or 60 mm, or 50 mm, or 40 mm, or 30 mm, or 20 mm, or 10 mm from the edge of the wafer.

The plurality of contact elements may extend perpendicularly to a main plane, or main surface or main face of the support.

There may be three of the contact elements. Three contact elements may be preferred because contact points of the three contact elements that are configured to contact the wafer will always lie within a single plane. This may mean that the wafer is stably supported by the contact elements.

There may be only three of the contact elements, or exactly three of the contact elements.

In general the three contact elements are distributed around a centre of the support so as to form a triangle around a centre of the support (when the support is viewed perpendicularly to a main plane, or main surface or main face of the support).

The three contact elements may be positioned so as to form an equilateral triangle around a centre of the support (when the support is viewed perpendicularly to a main plane, or main surface or main face of the support).

The centre of the support may mean a point or position where a weighing axis or weighing direction of the weighing device (for example a direction along which a load cell of the weighing device measures a weight force) passes through the support (when the support is viewed perpendicularly to a main plane, or main surface or main face of the support).

The centre of the support may mean a point or position that is located underneath a centre of a wafer when the wafer is loaded on the weighing device.

The centre of the support may mean a point or position that is located underneath a centre of mass of the wafer when the wafer is loaded on the weighing device.

However, in other embodiments there may be a different number of contact elements. For example, there may be more than three of the contact elements.

There may be three or more of the contact elements.

The term contact element may mean a contact member, or contact part.

The plurality of contact elements may be configured to contact the underside of the wafer less than or equal to a distance of D/4, or D/5, or D/6, or D/7, or D/8, or D/9, or D/10, or D/11, or D/12, or D/13, or D/14, or D/15, or D/16, or D/17, or D/18, or D/19, or D/20 from the edge of the wafer.

Each of the plurality of contact elements may be configured to contact the underside of the wafer less than or equal to the specified distance from the edge of the wafer.

Each of the plurality of contact elements may be configured to contact the underside of the wafer at a respective position on the underside of the wafer that is less than or equal to the specified distance from the edge of the wafer.

The plurality of contact elements may comprise or be pins, for example wafer support pins. For example, each of the contact elements may comprise or be a pin.

Each of the plurality of contact elements may comprise a rod or cylinder.

The weighing device may be for performing a weight measurement on a wafer having a diameter of 200 mm, or 300 mm, or 450 mm. The specific diameter D may therefore be 200 mm, or 300 mm, or 450 mm.

The plurality of contact elements may comprise two or more different lengths of contact element. For example, each of the plurality of contact elements may have a different respective length.

There may be three contact elements (exactly or only three contact elements), and each of the three contact elements may have a different respective length.

There may be three or more contact elements, and the three or more contact elements may comprise two or more different lengths of contact element.

The plurality of contact elements may comprise two or more different lengths of contact element so as to support the semiconductor wafer in a more level or more horizontal orientation (compared to a case where the contact elements all have the same length), and/or so as to support the semiconductor wafer in a substantially or approximately level or horizontal orientation, and/or so as to support the wafer in a level or horizontal orientation.

A main plane or main face or main surface of the support (for example balance pan or weighing pan) may not be level or horizontal.

For example, the weighing device may comprise a load cell, and the load cell and/or a housing that encloses the load cell may not be level. Therefore, the support connected or coupled to the load cell may also not be level.

Alternatively, the load cell may be level, but the support may not be level, for example due to variations in manufacture of the support.

In this case, providing contact elements having different lengths means that the wafer may be supported by the support in a more level or horizontal orientation than if the contact elements all had the same length.

The lengths of the contact elements may be configured so that tops of the contact elements are approximately or substantially arranged in a horizontal plane, or an approximately horizontal plane (for example a plane inclined by less than 5 degrees to horizontal), or a plane that is more level and/or closer to horizontal than a main plane or main surface or main face of the support.

A plane formed by tops of the contact elements (or a best fit plane fitted to tops of the contact elements) may be more level/closer to level (or horizontal) than a plane formed by bottoms of the contact elements or a main plane or main surface or main face of the support.

Therefore, when the wafer is loaded on the weighing device, the semiconductor wafer is supported in a more level or more horizontal orientation than if the contact elements all had the same length.

In general, the lengths of the contact elements may be configured and/or set and/or selected to support the wafer in a more level (or horizontal) orientation (compared to if the contact elements all had the same length), or a substantially level (or horizontal) orientation, or a level (or horizontal) orientation.

The length of the contact element may mean a distance by which the contact element extends in the direction perpendicular to the main plane, or main face or main surface of the support from the main plane, or main face or main surface of the support.

The length of the contact element may mean a longitudinal length or dimension of the contact element.

One or more of the plurality of contact elements may have an adjustable length. For example, each of the plurality of contact elements may have an adjustable length. Therefore, the lengths of the one or more contact elements may be adjusted to achieve the desired lengths.

According to a second aspect of the present invention there is provided an apparatus comprising the weighing device according to the first aspect of the present invention.

The apparatus according to the second aspect of the present invention may include any of the features of the weighing device according to the first aspect of the present invention described above.

The apparatus according to the second aspect of the present invention may have any one, or, where compatible, any combination of the following optional features.

The apparatus may be for determining information relating to the mass of a semiconductor wafer, such as the mass of the semiconductor wafer, a change in the mass of the semiconductor wafer, or a difference between the mass of the semiconductor wafer and the mass of a reference mass.

The apparatus may be a semiconductor wafer mass metrology apparatus.

The apparatus may be configured to handle a specific diameter of semiconductor wafer, such as 200 mm or 300 mm, or 450 mm.

The apparatus may include a wafer transporter configured to move wafers onto the support of the weighing device. The wafer transporter may be configured for transporting wafers having the specific diameter.

The apparatus may comprise monitoring means configured to determine the buoyancy exerted on the wafer by the atmosphere in the measurement chamber.

The calculation of the mass of the semiconductor wafer may comprise compensating for the buoyancy exerted on the wafer by the atmosphere in the measurement chamber.

The monitoring means may include one of more of: a temperature monitor, a pressure monitor and a humidity monitor (or temperature sensor, or pressure sensor, or humidity sensor).

The apparatus according to the second aspect of the present invention may comprise a plurality of wafer support elements for supporting the wafer from beneath while the wafer is being loaded onto the support.

The term wafer support element may mean a wafer support part or wafer support member.

The term wafer support element may mean a wafer contact element, wafer contact part, or wafer contact member.

The wafer support elements being for supporting the wafer from beneath while the wafer is being loaded onto the support may mean that the wafer support elements are for contacting the underside of the wafer so as to support the wafer while the wafer is being loaded onto the support.

In other words, the wafer support elements supporting the wafer from beneath may mean that points of contact between the wafer support elements and the wafer are beneath or below the wafer, and/or on an underside or bottom of the wafer.

The wafer support elements being for supporting the wafer from beneath while the wafer is being loaded onto the support may mean that the wafer support elements are for contacting the wafer from beneath or below the wafer so as to support the wafer while the wafer is being loaded onto the support.

Each of the plurality of wafer support elements may be configured to contact the underside of the wafer while the wafer is being loaded onto the support so as to support the wafer.

For example, there may be three of the wafer support elements, or three or more of the wafer support elements.

The wafer support elements may comprise wafer holders, or wafer hangers.

The wafer support elements may be used to support the wafer while the wafer is transported onto the support.

The wafer support elements may be configured to contact the wafer from beneath so as to support the wafer before the wafer is loaded on the support.

The wafer support elements may be configured not to contact the wafer once the wafer has been loaded onto the support.

The wafer support elements may be configured to support a wafer having a diameter of 200 mm, or 300 mm, or 450 mm.

A contact element of the plurality of contact elements may be configured to contact the underside of the wafer (when the wafer is supported by the support) less than or equal to 50 mm from a position where a wafer support element of the plurality of wafer support elements is configured to contact the underside of the wafer (when the wafer is supported by the wafer support elements).

The contact element of the plurality of contact elements may be configured to contact a position on the underside of the wafer (when the wafer is supported by the support) that is less than or equal to 50 mm from a position on the underside of the wafer where a wafer support element of the plurality of wafer support elements is configured to contact the underside of the wafer (when the wafer is supported by the wafer support elements).

In particular, if the wafer is not level and/or not flat, it is possible that the edge of the wafer may come into contact with one or more of the wafer support elements while the wafer is loaded onto the weighing device. In that case, part of the weight of the wafer may be supported by the wafer support element, such that the weight measurement is incorrect or inaccurate.

In this aspect, a contact element of the plurality of contact elements is configured to contact the underside of the wafer (when the wafer is supported by the support) less than or equal to 50 mm from a position where a wafer support element of the plurality of wafer support elements is configured to contact the underside of the wafer (when the wafer is supported by the wafer support elements). Therefore, the position of the edge of the wafer may be better controlled and/or more clearly defined in the proximity of the wafer support element, so that contact between the wafer and the wafer support element when the wafer is supported by the support may be prevented or reduced.

The 50 mm distance may be measured along a plane of the wafer, and/or along the bottom or lower surface of the wafer.

The contact element may be configured to contact the underside of the wafer less than or equal to 40 mm, or 30 mm, or 20 mm, or 10 mm, from the position where the wafer support element is configured to contact the underside of the wafer.

Each of the plurality of contact elements may be configured to contact the underside of the wafer less than or equal to 50 mm, or 40 mm, or 30 mm, or 20 mm, or 10 mm from a position where a wafer support element of the plurality of wafer support elements is configured to contact the underside of the wafer.

Each of the plurality of contact elements may be configured to contact the underside of the wafer less than or equal to 50 mm, or 40 mm, or 30 mm, or 20 mm, or 10 mm from a position where a respective wafer support element of the plurality of wafer support elements is configured to contact the underside of the wafer.

Each of the plurality of contact elements may be configured to contact the underside of the wafer at a respective position on the underside of the wafer that is less than or equal to 50 mm, or 40 mm, or 30 mm, or 20 mm, or 10 mm from a position on the underside of the wafer where a wafer support element (or respective wafer support element) of the plurality of wafer support elements is configured to contact the underside of the wafer.

There may be three (only or exactly three) contact elements and three (only or exactly three) wafer support elements. Each of the three contact elements may be configured to contact the underside of the wafer less than or equal to 50 mm, or 40 mm, or 30 mm, or 20 mm, or 10 mm from a position where a respective wafer support element of the three wafer support elements is configured to contact the underside of the wafer.

There may be three or more contact elements.

There may be three or more wafer support elements.

A number of the contact elements may be the same as a number of the wafer support elements. Each of the contact elements may be configured to contact the underside of the wafer less than or equal to 50 mm, or 40 mm, or 30 mm, or 20 mm, or 10 mm from a position where a respective wafer support element of the wafer support elements is configured to contact the underside of the wafer.

The apparatus may comprise a measurement chamber having a lid; the weighing device may be inside the measurement chamber; and the plurality of wafer support elements may be attached to, or connected to, or integral to, or provided on the lid.

The apparatus may comprise a measurement chamber having a lid; the weighing device may be inside the measurement chamber; and the plurality of wafer support elements may be on an underside of the lid. The underside of the lid is the surface of the lid that faces the inside of the measurement chamber when the lid is on the measurement chamber.

The measurement chamber may house and/or enclose the weighing device.

The lid may be a top surface or part of the measurement chamber.

The plurality of wafer support elements may be attached to an underside of the lid.

The lid may be removable from the measurement chamber.

The lid may be movable vertically upwards relative to a main body of the measurement chamber to remove the lid from the main body of the measurement chamber, and movable vertically downwards relative to the main body of the measurement chamber to position the lid on the main body of the measurement chamber.

For example, the apparatus may comprise one or more actuators connected or coupled to the lid and operable to move the lid relative to the main body of the measurement chamber. Movement of the lid may be controlled by a controller of the apparatus.

The wafer support elements may be configured to suspend the wafer beneath the bottom surface of the lid.

The wafer may therefore be held or supported by the wafer support elements beneath the bottom surface of the lid with a predetermined spacing between the wafer and the bottom surface of the lid.

The apparatus may be configured (for example the wafer support elements and/or the contact elements may be configured and/or adapted and/or arranged and/or positioned) so that the wafer is loaded onto the support from the wafer support elements when the lid is positioned on the measurement chamber.

For example, when the lid is positioned on the measurement chamber, contact points of the contact elements may be vertically higher than contact points of the wafer support elements.

According to a third aspect of the present invention there is provided a weighing device for performing a weight measurement on a wafer, the weighing device comprising a support for supporting the wafer during the weight measurement, wherein:
the support comprises a plurality of contact elements located at least 50 mm from a centre of the support and configured to contact an underside of the wafer to support the wafer during the weight measurement.

Therefore, the plurality of contact elements may support a 300 mm semiconductor wafer closer to the edge of the wafer than has been the case previously.

The weighing device according to the third aspect of the present invention may have any of the features of the weighing device according to the first aspect of the present invention discussed above, unless incompatible with the features of the third aspect described herein.

The weighing device according to the third aspect of the present invention may have any one, or where compatible, any combination of the following optional features.

At least 50 mm from the centre of the support means greater than or equal to, or more than or equal to, 50 mm from the centre of the support.

The wafer may be a semiconductor wafer, such as a silicon wafer.

The centre of the support may mean a centre of the support when the support is viewed perpendicularly to a main plane, or main face, or main surface of the support.

The centre of the support may mean a point where a weighing axis or weighing direction of the weighing device (for example a direction along which a load cell of the weighing device measures a weight force) passes through the support.

The centre of the support may mean a point or position on the support that is beneath a centre of the wafer when the wafer is loaded on the support.

The centre of the support may mean a point or position that is located underneath a centre of mass of the wafer when the wafer is loaded on the weighing device.

The centre of the support may be a point on the support above a central shaft of the support.

The plurality of contact elements may be located at least 60 mm, or at least 70 mm, or at least 75 mm, or at least 80 mm, or at least 90 mm, or at least 100 mm, or at least 110 mm, or at least 120 mm, or at least 130 mm, or at least 140 mm, from the centre of the support.

The plurality of contact elements may each be located the same distance from the centre of the support. Alternatively, each of the contact elements may be located at a different respective distance from the centre of the support.

The distance from the centre of the support may be measured when the support is viewed perpendicularly to a main plane, or main face or main surface of the support.

The distance from the centre of the support may be a radial distance from the centre of the support, for example in a main plane, or main face or main surface of the support.

The distance from the centre of the support may be measured along a main plane, or main face or main surface of the support.

There may be three or more of the contact elements.

The weighing device may be for performing a weight measurement on a wafer having a diameter of 300 mm.

The weighing device may be configured or adapted to perform a weight measurement on a wafer having a diameter of 300 mm.

The weighing device according to the third aspect may be included in an apparatus according to the second aspect, which may include any of the features of the second aspect discussed above, unless incompatible with the features of the third aspect described herein.

According to a fourth aspect of the present invention there is provided a weighing device for performing a weight measurement on a wafer having a diameter of 200 mm, the weighing device comprising a support for supporting the wafer during the weight measurement, wherein: the support comprises a plurality of contact elements located at least 33 mm from a centre of the support and configured to contact an underside of the wafer to support the wafer during the weight measurement.

The weighing device according to the fourth aspect of the present invention may have any of the features of the weighing device according to the first aspect or third aspect of the present invention discussed above, unless incompatible with the features of the fourth aspect described herein.

The weighing device according to the fourth aspect of the present invention may have any one, or where compatible, any combination of the following optional features.

The plurality of contact elements may be located at least 40 mm, or at least 50 mm, or at least 60 mm, or at least 70 mm, or at least 80 mm, or at least 90 mm from the centre of the support.

There may be three or more of the contact elements.

The wafer may be a semiconductor wafer, such as a silicon wafer.

The weighing device according to the fourth aspect may be included in an apparatus according to the second aspect, which may include any of the features of the second aspect discussed above, unless incompatible with the features of the fourth aspect described herein.

According to a fifth aspect of the present invention there is provided a weighing device for performing a weight measurement on a wafer having a diameter of 450 mm, the weighing device comprising a support for supporting the wafer during the weight measurement, wherein: the support comprises a plurality of contact elements located at least 75 mm from a centre of the support and configured to contact an underside of the wafer to support the wafer during the weight measurement.

The weighing device according to the fifth aspect of the present invention may have any of the features of the weighing device according to the first aspect, third aspect or fourth aspect of the present invention discussed above, unless incompatible with the features of the fifth aspect described herein.

The weighing device according to the fifth aspect of the present invention may have any one, or where compatible, any combination of the following optional features.

The wafer may be a semiconductor wafer, such as a silicon wafer.

There may be three or more of the contact elements.

The plurality of contact elements may be located at least 85 mm, or at least 95 mm, or at least 105 mm, or at least 112.5 mm, or at least 115 mm, or at least 125 mm, or at least 135 mm, or at least 145 mm, or at least 155 mm, or at least 165 mm, or at least 175 mm, or at least 185 mm, or at least 195 mm, or at least 205 mm, or at least 215 mm from the centre of the support.

The weighing device according to the fifth aspect may be included in an apparatus according to the second aspect, which may include any of the features of the second aspect discussed above unless incompatible with the features discussed above, unless incompatible with the features of the fifth aspect described herein.

According to a sixth aspect of the present invention there is provided an apparatus comprising:
a weighing device for performing a weight measurement on a wafer, the weighing device comprising a support for supporting the wafer during the weight measurement, wherein the support comprises a plurality of contact elements configured to contact an underside of the wafer to support the wafer during the weight measurement; and
a plurality of wafer support elements for supporting the wafer from beneath while the wafer is being loaded onto the support;
wherein a contact element of the plurality of contact elements is configured to contact the underside of the wafer (when the wafer is supported by the support) less than or equal to 50 mm from a position where a wafer support element of the plurality of wafer support elements is configured to contact the underside of the wafer (when the wafer is supported by the wafer support elements).

The apparatus according to the sixth aspect of the present invention may include any of the features of the first to fifth aspects described above, unless incompatible with the features of the sixth aspect described herein.

The apparatus according to the sixth aspect of the present invention may include any one, or, where compatible, any combination of the following optional features.

The wafer support elements being for supporting the wafer from beneath while the wafer is being loaded onto the support may mean that the wafer support elements are for contacting the underside of the wafer so as to support the wafer while the wafer is being loaded onto the support.

In other words, the wafer support elements supporting the wafer from beneath may mean that points of contact between the wafer support elements and the wafer are beneath or below the wafer, and/or on an underside or bottom of the wafer.

The wafer support elements being for supporting the wafer from beneath while the wafer is being loaded onto the support may mean that the wafer support elements are for contacting the wafer from beneath or below the wafer so as to support the wafer while the wafer is being loaded onto the support.

Each of the plurality of wafer support elements may be configured to contact the underside of the wafer while the wafer is being loaded onto the support so as to support the wafer.

The contact element is configured to contact the underside of the wafer (when the wafer is supported by the support) at a position on the underside of the wafer that is less than or equal to 50 mm from a position on the underside of the wafer where a wafer support element of the plurality of wafer support elements is configured to contact the underside of the wafer (when the wafer is supported by the wafer support elements).

The wafer support elements may be configured not to contact the wafer once the wafer has been loaded onto the support.

The contact element may be configured to contact the underside of the wafer less than or equal to 40 mm, or 30 mm, or 20 mm, or 10 mm, from the position where the wafer support element is configured to contact the underside of the wafer.

Each of the plurality of contact elements may be configured to contact the underside of the wafer less than or equal to 50 mm, or 40 mm, or 30 mm, or 20 mm, or 10 mm from a position where a wafer support element of the plurality of wafer support elements is configured to contact the underside of the wafer.

Each of the plurality of contact elements may be configured to contact the underside of the wafer less than or equal to the specified distance from a position where a respective one of the plurality of wafer support elements is configured to contact the underside of the wafer.

Each of the plurality of contact elements may be configured to contact the underside of the wafer at a respective position on the underside of the wafer that is less than or equal to the specified distance from a position on the underside of the wafer where a respective one of the plurality of wafer support elements is configured to contact the underside of the wafer.

There may be three (only or exactly three) contact elements.

There may be three (only or exactly three) wafer support elements.

Each of the three contact elements may be configured to contact the underside of the wafer less than or equal to the specified distance from a position where a respective one of the three wafer support elements is configured to contact the underside of the wafer.

There may be three or more contact elements.

There may be three or more wafer support elements.

A number of the contact elements may be the same as a number of the wafer support elements. Each of the contact elements may be configured to contact the underside of the wafer less than or equal to 50 mm, or 40 mm, or 30 mm, or 20 mm, or 10 mm from a position where a respective wafer support element of the wafer support elements is configured to contact the underside of the wafer.

The plurality of contact elements may be pins. For example, each of the contact elements may comprise or be a pin.

The plurality of contact elements may comprise two or more different lengths of contact element.

The plurality of contact elements may comprise two or more different lengths of contact element, so as to support the wafer in a more level orientation during the weight measurement.

For example, there may be three contact elements and each of the three contact elements may have a different respective length.

There may be three or more contact elements, and the three or more contact elements may comprise two or more different lengths of contact element.

One or more of the plurality of contact elements may have an adjustable length.

The wafer may be a semiconductor wafer, for example a silicon wafer.

The weighing device may be for performing a weight measurement on a wafer having a specific diameter D; and one of more of the plurality of contact elements may be configured to contact an underside of the wafer less than or equal to a distance of D/3, or D/4, or D/5, or D/6, or D/7, or D/8, or D/9, or D/10, or D/11, or D/12, or D/13, or D/14, or D/15, or D/16, or D/17, or D/18, or D/19, or D/20 from an edge of the wafer.

The weighing device may be for performing a weight measurement on a wafer having a diameter of 200 mm, or 300 mm, or 450 mm.

The weighing device may be configured and/or adapted to perform the weight measurement on the wafer having the specific diameter D.

One of more of the plurality of contact elements may be configured to contact an underside of the wafer less than or equal to 100 mm, or 90 mm, or 80 mm, or 70 mm, or 60 mm, or 50 mm, or 40 mm, or 30 mm, or 20 mm, or 10 mm from an edge of the wafer.

One or more of the plurality of contact elements may be located at least 50 mm, or at least 60 mm, or at least 70 mm, or at least 80 mm, or at least 90 mm, or at least 100 mm, or at least 110 mm, or at least 120 mm, or at least 130 mm, or at least 140 mm from a centre of the support.

The apparatus may comprise a measurement chamber having a lid; the weighing device may be inside the measurement chamber; and the plurality of wafer support elements may be attached to the lid (and/or provided on an underside of the lid).

The apparatus may be configured so that the wafer is loaded onto the support from the wafer support elements when the lid is positioned on the measurement chamber.

According to a seventh aspect of the present invention there is provided a weighing device for performing a weight measurement on a wafer, the weighing device comprising a support for supporting the wafer during the weight measurement, wherein:
the support comprises a plurality of contact elements configured to contact an underside of the wafer to support the wafer during the weight measurement; and
the plurality of contact elements include two or more different lengths of contact element.

The weighing device according to the seventh aspect of the present invention may include any of the features of the weighing device according to the first, third, fourth or fifth aspect of the present invention discussed above, unless incompatible with the features of the seventh aspect described herein.

The weighing device according to the seventh aspect of the present invention may comprise any one, or where compatible, any combination of the following optional features.

The plurality of contact elements may comprise two or more different lengths of contact element so as to support the semiconductor wafer in a more level orientation during the weight measurement.

There may be three or more of the contact elements.

There may be exactly or only three of the contact elements.

The three contact elements may have different respective lengths.

There may be three or more contact elements, and the three or more contact elements may comprise two or more different lengths of contact element.

The wafer may be a semiconductor wafer, for example a silicon wafer.

At least one of the plurality of contact elements may have an adjustable length.

The weighing device according to the seventh aspect of the present invention may be included in an apparatus according to the second or sixth aspect of the present invention discussed above, which may include any of the features of the second or sixth aspect discussed above, unless incompatible with the features of the seventh aspect described herein.

According to an eighth aspect of the present invention there is provided a weighing device for performing a weight measurement on a wafer, the weighing device comprising a support for supporting the wafer during the weight measurement, wherein:
the support comprises a plurality of contact elements configured to contact an underside of the wafer to support the wafer during the weight measurement; and
at least one of the plurality of contact elements has an adjustable length.

The weighing device according to the eighth aspect of the present invention may include any of the features of the weighing device according to the first, third, fourth, fifth or seventh aspect of the present invention discussed above, unless incompatible with the features of the eighth aspect described herein.

There may be three or more of the contact elements.

The wafer may be a semiconductor wafer, for example a silicon wafer.

The weighing device according to the eighth aspect of the present invention may be included in an apparatus according to the second or sixth aspect of the present invention discussed above, which may include any of the features of the second or sixth aspect discussed above, unless incompatible with the features of the eighth aspect described herein.

According to a ninth aspect of the present invention there is provided a method comprising: performing a weight measurement on a semiconductor wafer having a specific diameter D; wherein the method comprises supporting the wafer from beneath less than or equal to a distance of D/3 from an edge of the wafer during the weight measurement.

The method according to the ninth aspect may include any of the features of the first to eighth aspects discussed above, unless incompatible with the features of the ninth aspect described herein.

Supporting the wafer from beneath may mean that a point of contact with the wafer is on the underside or bottom of the wafer.

Supporting the wafer from beneath less than or equal to a distance of D/3 from an edge of the wafer during the weight measurement may comprise or mean contacting the wafer at a position on an underside of the wafer less than or equal to a distance of D/3 from an edge of the wafer during the weight measurement.

Supporting the wafer from beneath less than or equal to a distance of D/3 from an edge of the wafer during the weight measurement may comprise or mean contacting the wafer at a plurality of positions on an underside of the wafer, each of which is less than or equal to a distance of D/3 from an edge of the wafer, during the weight measurement.

The method may comprise supporting the wafer from beneath less than or equal to a distance of D/4, or D/5, or D/6, or D/7, or D/8, or D/9, or D/10, or D/11, or D/12, or D/13, or D/14, or D/15, or D/16, or D/17, or D/18, or D/19, or D/20 from the edge of the wafer.

Supporting the wafer from beneath less than or equal to the specified distance from the edge of the wafer comprises contacting an underside of the wafer at a position on the underside of the wafer that is less than or equal to the specified distance from the edge of the wafer.

The method may comprise supporting the wafer from beneath using a plurality of contact elements configured to contact the underside of the wafer less than or equal to the specified distance from the edge of the wafer.

There may be three (only or exactly three) of the contact elements. There may be three or more of the contact elements.

The wafer may be a semiconductor wafer, such as a silicon wafer.

According to a tenth aspect of the present invention there is provided a method comprising:
providing a weighing device for performing a weight measurement on a wafer, the weighing device comprising a support for supporting the wafer during the weight measurement, the support comprising a plurality of contact elements configured to contact an underside of the wafer to support the wafer during the weight measurement;
wherein the method comprises setting lengths of the plurality of contact elements so as to support the wafer in a more level orientation during the weight measurement.

The method according to the tenth aspect may include any of the features of the first to ninth aspects discussed above, unless incompatible with the features of the tenth aspect described herein.

According to an eleventh aspect of the present invention there is provided an apparatus comprising: a measurement chamber, wherein the measurement chamber has a removable lid; and a plurality of wafer support elements for supporting a wafer from beneath, wherein the plurality of wafer support elements are provided on the lid.

The apparatus according to the eleventh aspect of the present invention may include any of the features of the first to tenth aspects discussed above, unless incompatible with the features of the eleventh aspect described herein.

For example, the lid and/or the wafer support elements of this aspect may have any of the features of the lid and/or the wafer support elements of any of the other aspects discussed above, unless incompatible.

The apparatus according to the eleventh aspect of the present invention may include any one, or, where compatible, any combination of the following optional features.

The wafer support elements being for supporting the wafer from beneath may mean that the wafer support elements are for contacting the underside of the wafer so as to support the wafer.

In other words, the wafer support elements supporting the wafer from beneath may mean that points of contact between the wafer support elements and the wafer are beneath or below the wafer, and/or on an underside or bottom of the wafer.

The wafer support elements being for supporting the wafer from beneath may mean that the wafer support elements are for contacting the wafer from beneath or below the wafer so as to support the wafer.

Each of the plurality of wafer support elements may be configured to contact the underside of the wafer so as to support the wafer.

The wafer support elements being provided on the lid may mean that the wafer support elements are positioned on the lid, or attached to the lid, or fixed to the lid, or integral with the lid.

The wafer support elements may be provided on an underside or bottom surface or bottom side of the lid.

The underside of the lid means a side of the lid that faces the inside of the measurement chamber when the lid is positioned on the measurement chamber.

The wafer support elements may be wafer hangers.

There may be three (only or exactly three) of the wafer support elements. There may be three or more of the wafer support elements.

The three wafer support elements may be configured to be evenly spaced around a circumference of the wafer when the wafer is supported by the three wafer support elements.

For example, the three wafer support elements may be configured so as to form an equilateral triangle between the three wafer support elements.

Contact points of the three wafer support elements may be configured to be evenly spaced around a circumference of the wafer when the wafer is supported by the three wafer support elements.

For example, the contact points of the three wafer support elements may be configured so as to form an equilateral triangle between the contact points of the three wafer support elements.

The apparatus may comprise a weighing device for performing a weight measurement on a wafer, wherein the weighing device is inside the measurement chamber.

The measurement chamber may house and/or enclose the weighing device.

The lid may be a top surface or part of the measurement chamber.

The lid may be movable vertically upwards relative to a main body of the measurement chamber to remove the lid from the main body of the measurement chamber, and movable vertically downwards relative to the main body of the measurement chamber to position the lid on the main body of the measurement chamber.

For example, the apparatus may comprise one or more actuators connected or coupled to the lid and operable to move the lid relative to the main body of the measurement chamber. Movement of the lid may be controlled by a controller of the apparatus.

The wafer support elements may be configured to suspend the wafer beneath the underside (bottom surface) of the lid.

The wafer may therefore be held or supported by the wafer support elements beneath the underside (bottom surface) of the lid with a predetermined spacing between the wafer and the underside of the lid.

The apparatus may be configured (for example the wafer support elements and/or the weighing device may be configured and/or adapted and/or arranged and/or positioned) so that the wafer is loaded onto the weighing device from the wafer support elements when the lid is positioned on the measurement chamber.

The weighing device may comprise a support for supporting the wafer during the weight measurement. The apparatus may be configured (for example the wafer support elements and/or the support may be configured and/or adapted and/or arranged and/or positioned) so that the wafer is loaded onto the support from the wafer support elements when the lid is positioned on the measurement chamber.

The support may comprise a plurality (for example three or more) contact elements configured to contact an underside of the wafer to support the wafer during the weight measurement.

When the lid is positioned on the measurement chamber, contact points of the contact elements may be vertically higher than contact points of the wafer support elements.

The apparatus may comprise a seal located between the lid and the measurement chamber when the lid is positioned on the measurement chamber. For example, the seal may be provided on the lid and/or on a main body of the measurement chamber.

Each of the plurality of wafer support elements may be substantially L-shaped.

Each of the plurality of wafer support elements may be configured to extend inwards relative to a wafer supported by the plurality of wafer support elements.

Each of the plurality of wafer support elements may be configured to extend radially inwards relative to a wafer supported by the plurality of wafer support elements.

For example, each of the wafer support elements may comprise a first portion that extends substantially vertically downwards from the underside of the lid, and a second portion that extends substantially horizontally from the first portion. The second portions may be arranged to extend substantially radially inwards relative to a wafer supported by the wafer support elements.

The second portions of the wafer support elements may be sufficiently long that the wafer can be inserted between any two of the wafer support elements from the side (i.e. laterally) and then lowered onto the second portions of the wafer support elements.

For example, the wafer may be supported from underneath by an end effector or other wafer supporter and the end effector may be used to position the wafer between the wafer support elements and to lower the wafer onto the second portions of the wafer support elements.

The wafer support elements may each comprise a protrusion, for example a bump or pin, for contacting the underside of the wafer when the wafer is supported by the wafer support element. This may minimise contact between the wafer and the wafer support elements, and therefore minimise contamination of the wafer. For example, the protrusion may be located on an upper side of the second portions of the wafer hangers.

Where compatible, the features of one or more of any of the above described aspects of the present invention can be combined in any order.

### Brief description of the drawings

Embodiments of the present invention will now be discussed, by way of example only, with reference to the accompanying Figures, in which:
FIG. 1 illustrates an apparatus according to a comparative example;
FIG. 2 illustrates the apparatus according to the comparative example;
FIG. 3 illustrates an apparatus according to a first embodiment of the present invention;
FIG. 4 illustrates the apparatus according to the first embodiment of the present invention;
FIGS. 5(a) and 5(b) illustrate a balance pan that can be used in the first embodiment of the present invention;
FIG. 6 illustrates an apparatus according to a second embodiment of the present invention;
FIG. 7 illustrates the apparatus according to the second embodiment of the present invention;
FIGS. 8(a) and 8(b) illustrate a balance pan that can be used in the second embodiment of the present invention;
FIG. 9 illustrates an apparatus according to a third embodiment of the present invention;
FIGS. 10(a) and 10(b) illustrate a balance pan that can be used in the third embodiment of the present invention; and
FIGS. 11(a) and 11(b) illustrate a lid for a measurement chamber that can be used in embodiments of the present invention.

### Detailed description of the preferred embodiments and further optional features of the invention

Aspects and embodiments of the present invention will now be discussed with reference to the accompanying figures. Further aspects and embodiments will be apparent to those skilled in the art.

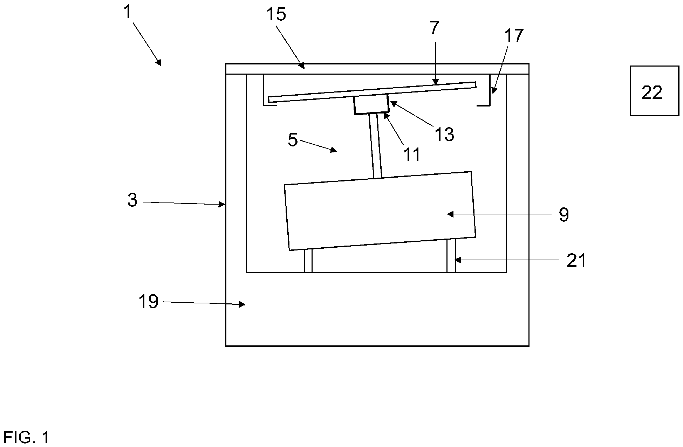

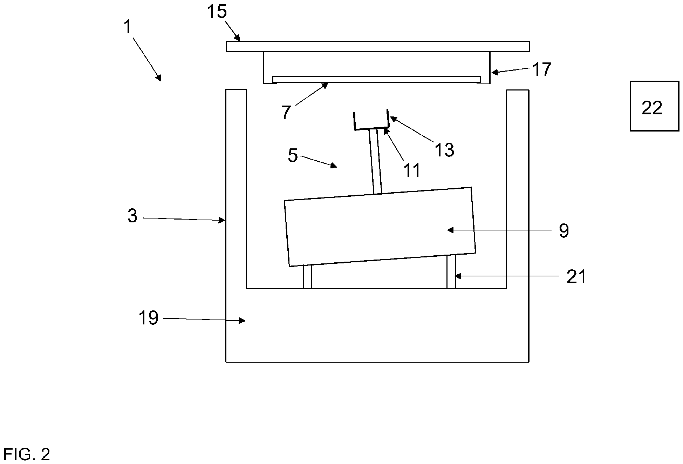

FIGS. 1 and 2 illustrate an apparatus 1 according to a comparative example. The apparatus 1 may be a semiconductor wafer mass metrology apparatus for determining information relating to the mass of a semiconductor wafer, such as the mass of the semiconductor wafer, a change in the mass of the semiconductor wafer, or a difference between the mass of the semiconductor wafer and the mass of a reference mass or counterweight.

The apparatus 1 comprises a measurement chamber 3. A weighing device 5 for performing a weighing measurement on a semiconductor wafer 7 is contained in the measurement chamber 3. The measurement chamber 3 houses and/or encloses the weighing device 5.

The apparatus 1 may be configured to determine the mass of the semiconductor wafer 7, a change in the mass of the semiconductor wafer 7, or a difference between the mass of the semiconductor wafer 7 and the mass of a reference mass or counterweight, based on at least a weight measurement performed on the semiconductor wafer 7 by the weighing device 5.

The weighing device 5 is configured to generate measurement output indicative of the weight being measured, for example the weight of the semiconductor wafer 7 loaded on the weighing device 5. The weighing device 5 may measure the weight of the semiconductor wafer 7, or a change in the weight of the semiconductor wafer 7, or a difference between the weight of the semiconductor wafer 7 and the weight of a reference mass or counterweight.

The measurement output of the weighing device 5 may be an electrical signal or electrical output that corresponds to the weight being measured. For example, a magnitude of a current or a voltage of the electrical signal or electrical output may correspond to the weight being measured.

The measurement chamber 3 may provide a controlled environment around the weighing device 5. For example, the measurement chamber 3 may minimise air currents around the weighing device 5. The measurement chamber 3 may additionally or alternatively maintain a substantially uniform temperature around the weighing device 5. For example, the measurement chamber 3 may include a heater or cooler for maintaining an interior of the measurement chamber 3 at a substantially uniform temperature, e.g., within +/- 0.1 °C.

The weighing device 5 comprises a load cell 9 (weight force sensor or weight force transducer). The load cell 9 is configured to convert a force loaded onto the load cell 9 into an electrical signal or electrical output corresponding to the force (i.e. a magnitude of a current or a voltage of the electrical signal or electrical output corresponds to a magnitude of the force).

The weighing device 5 further comprises a balance pan (or weighing pan) 11 for supporting the semiconductor wafer 7 during the weight measurement. In particular, the balance pan 11 supports the weight of the semiconductor wafer 7 during the weight measurement.

The balance pan 11 is coupled or connected to the load cell 9, so that a weight force applied to the balance pan 11 is applied to the load cell 9 and measured by the load cell 9. For example, the balance pan 11 may comprise a shaft that is coupled or connected to the load cell 9.

The balance pan 11 comprises a plurality of wafer support pins 13 (contact elements). The wafer support pins 13 extend perpendicularly to a main plane or main surface or main face of the balance pan 11. Specifically, the wafer support pins 13 extend perpendicularly to a main plane or main surface or main face of the balance pan 11 that faces the semiconductor wafer 7 when the semiconductor wafer 7 is loaded on the balance pan 11.

In this comparative example the balance pan 11 comprises three wafer support pins 13 (exactly or only three wafer support pins 13), but a different number of wafer support pins 13 may be provided. For example, in other embodiments there may be three or more of the wafer support pins 13.

The wafer support pins 13 are configured to contact an underside of a semiconductor wafer 7 loaded on the balance pan 11 to support the semiconductor wafer 7 during the weight measurement.

The wafer support pins 13 may be positioned so as to form a triangle, such as an equilateral triangle, around the centre of the balance pan 11 (when the balance pan 11 is viewed perpendicularly to a main plane, or main surface or main face of the balance pan 11).

In this comparative example each of the wafer support pins 13 is located 40 mm or less from a centre of the balance pan (when the balance pan 11 is viewed perpendicularly to a main plane, or main surface or main face of the balance pan).

When a 300 mm diameter semiconductor wafer 7 is loaded on the balance pan 11, each of the wafer support pins 13 is therefore configured to contact an underside of the semiconductor wafer 7 more than 110 mm from the edge (e.g. outer circumferential edge or peripheral edge) of the semiconductor wafer 7.

As shown in FIGS. 1 and 2, the measurement chamber 3 has a removable lid 15 (top surface). In particular, the lid 15 can be moved vertically upwards relative to a main body 19 of the measurement chamber 3 to remove the lid 15 from the main body 19 of the measurement chamber 3, and moved vertically downwards relative to the main body 19 of the measurement chamber 3 to position the lid on the main body 19 of the measurement chamber 3.

For example, the apparatus 1 may comprise one or more actuators connected or coupled to the lid 15 and operable to move the lid 15 relative to the main body of the measurement chamber 19. Movement of the lid 15 may be controlled by a controller of the apparatus 1.

A plurality of wafer hangers 17 are attached to a bottom surface of the lid 15. The plurality of wafer hangers 17 are configured to contact the semiconductor wafer 7 from beneath so as to support the semiconductor wafer 7 while the semiconductor wafer 7 is being loaded on the balance pan 11.

In this comparative example there are three wafer hangers 17, but a different number of wafer hangers 17 can be provided.

In particular, the wafer hangers 17 are configured to suspend the semiconductor wafer 7 beneath the bottom surface of the lid 15.

The number of the wafer hangers 17 may be the same as the number of the wafer support pins 13. Preferably, there are three wafer hangers 17 and three wafer support pins 13. There may be three or more wafer support pins 13 and three or more wafer hangers 17.

The semiconductor wafer 7 is therefore held or supported by the wafer hangers 17 beneath the bottom surface of the lid 15 with a predetermined spacing between the semiconductor wafer 7 and the bottom surface of the lid 15.

FIG. 2 shows the lid 15 removed from the main body 19 of the measurement chamber 3, with the semiconductor wafer 7 supported beneath the lid 15 by the wafer hangers 17.

FIG. 1 shows the lid 15 positioned on the main body 19 of the measurement chamber 3.

As shown in FIG. 1, the apparatus 1 is configured (for example the wafer hangers 17 and/or the wafer support pins 13 are configured and/or arranged and/or positioned) so that when the lid 15 is positioned on the main body 19 of the measurement chamber 3, the semiconductor wafer 7 is loaded onto the weighing apparatus 5 and supported by the balance pan 11.

In particular, when the lid 15 is positioned on the main body 19 of the measurement chamber 3, the tops of the wafer support pins 13 of the balance pan 11 are located vertically higher within the measurement chamber 3 than portions of the wafer hangers 17 that are configured to contact the underside of the semiconductor wafer 7. Therefore, when the lid 15 is positioned on the main body 19 of the measurement chamber 3, the semiconductor wafer 7 is supported on the tops of the wafer support pins 13 and not on the portions of the wafer hangers 17 that are configured to contact the underside of the semiconductor wafer 7.

As mentioned above, in the manufacturing process of a load cell such as the load cell 9, a configuration and/or position and/or orientation of the load cell 9 (and/or a housing enclosing the load cell 9) is setup for optimal performance of the load cell 9. In this optimal setup the load cell 9 (and/or a housing enclosing the load cell 9) is often not level. In other words, a weighing axis or weighing direction of the load cell 9 (a direction along which the load cell 9 measures a weight force) may not be vertical, and/or a top surface and/or a bottom surface of the load cell 9 (and/or a housing enclosing the load cell 9) may not be horizontal.

This optimal setup may be achieved by the load cell 9 (or a housing enclosing the load cell 9) having a plurality of legs 21 (or supports) for supporting the load cell 9 above a bottom surface of the measurement chamber 3, wherein the plurality of legs 21 have different lengths, so that the load cell 9 is not level. For example, the length of one or more of the legs 21 may be adjustable so that the legs 21 can be adjusted to setup the load cell 9 for optimal performance.

Therefore, as illustrated in FIGS. 1 and 2, in this comparative example the load cell 9 is not level (the degree of tilting of the load cell 9 is exaggerated in FIGS. 1 and 2 for illustrative purposes).

As illustrated in FIGS. 1 and 2, since the load cell 9 is not level, the balance pan 11 coupled or connected to the load cell 9 is also not level. In other words, a main plane or main surface or main face of the balance pan 11 that faces the semiconductor wafer 7 when the semiconductor wafer 7 is loaded on the balance pan 11 is not level or not horizontal.

For example, since the load cell 9 is not level, a shaft of the balance pan 11 connected to the load cell 9 may not be vertical, and therefore a main plane or main surface or main face of the balance pan 11 may not be level or not be horizontal.

Therefore, when the semiconductor wafer 7 is loaded on the balance pan 11, the semiconductor wafer 7 is also not level or not horizontal, as illustrated in FIG. 1. In other words, a main plane or main surface or main face of the semiconductor wafer 7 is not level or not horizontal.

As shown in FIG. 1, if the balance pan 11 and therefore the semiconductor wafer 7 are not level, there can be significant deviations between the position of the edge of the semiconductor wafer 7 that would be expected if the semiconductor wafer 7 was level or was horizontal and the actual position of the edge of the semiconductor wafer 7.

This deviation can cause a number of issues, as discussed above. For example, in some cases the deviation may be sufficient that the edge of the semiconductor wafer 7 comes into contact with one or more of the wafer hangers 17 while the semiconductor wafer 7 is loaded on the balance pan 11. This means that part of the weight of the semiconductor wafer 7 will be supported by one or more of the wafer hangers 17, and that the weight measurement will therefore be incorrect.

In addition, or alternatively, the deviation may mean that the semiconductor wafer 7 comes into contact with part of the measurement chamber 3, such as the lid 15 or the main body 19, or with another part of the apparatus 1. This means that part of the weight of the semiconductor wafer 7 will be supported by the part of the measurement chamber 3, or the another part of the apparatus 1, and that the weight measurement will therefore be incorrect.

The apparatus 1 may comprise monitoring means configured to determine the buoyancy exerted on the wafer by the atmosphere in the measurement chamber 3. For example, the apparatus may comprise sensors to monitor temperature, pressure and relative humidity inside the measurement chamber 3. A controller 22 or processor of the apparatus 1 may be configured to receive measurements from these sensors and use them to calculate the air density, which can be used to compensate for buoyancy in the weight measurement performed by the weighing device 5.

The apparatus 1 may therefore be configured to calculate the mass of the semiconductor wafer 7 based on measurement output of the weighing device 5 and a calculation of the buoyancy exerted on the semiconductor wafer 7 by the atmosphere in the measurement chamber 3.

The apparatus 1 and/or the weighing device 5 may be configured or adapted to handle semiconductor wafers having a specific diameter, for example 200 mm, 300 mm or 450 mm.

In this embodiment, the apparatus 1 and/or the weighing device is configured to handle semiconductor wafers having a diameter of 300 mm.

For example, the wafer hangers 17 and/or the balance pan 11 may be configured or adapted to handle semiconductor wafers having the specific diameter.

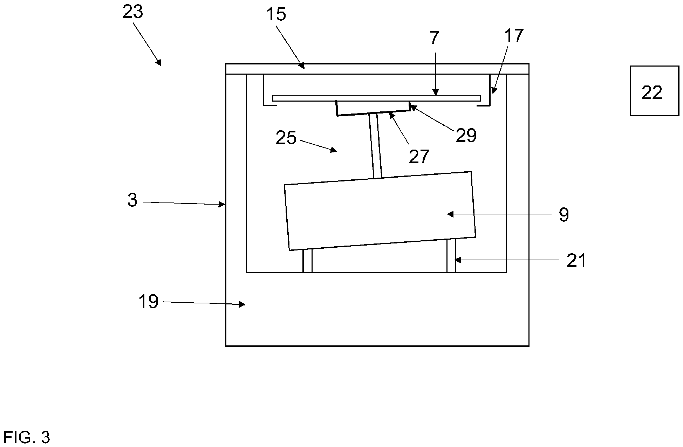

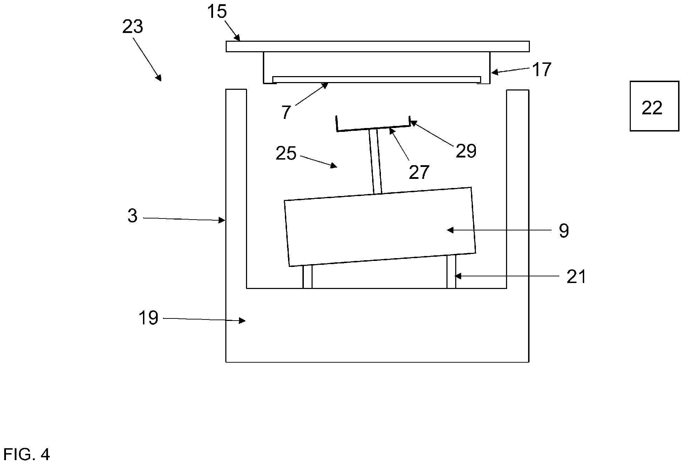

FIGS. 3 and 4 illustrate an apparatus 23 according to a first embodiment of the present invention. The apparatus 23 is a modified version of the apparatus 1 of the comparative example illustrated in FIGS. 1 and 2 and described above. The apparatus 23 may therefore have any of the features of the comparative example illustrated in FIGS. 1 and 2 and/or described above, unless incompatible with and/or replaced by the modifications described below.

In particular, as described below, the apparatus 23 differs from the apparatus 1 of the comparative example in that the apparatus 23 has a balance pan 27 that is different to the balance pan 11 of the apparatus 1. Any (one, or more than one, or all) of the other features of the apparatus 23 may be the same as in the apparatus 1 of the comparative example. These features are not repeated here for conciseness. Corresponding features are indicated using the same reference numbers in FIGS. 3 and 4.

In particular, in the apparatus 23 the weighing device 5 of the apparatus 1 of the comparative example is replaced with a weighing device 25 having a balance pan 27 that is different to the balance pan 11 of the weighing device 5. Any (one, or more than one, or all) of the other features of the weighing device 25 may be the same as in the weighing device 5 of the apparatus 1. For example, the weighing device 25 includes the same load cell 9 as the weighing device 5 and may include the same plurality of legs 21 as the weighing device 5.

The balance pan 27 comprises a plurality of wafer support pins 29. The wafer support pins 29 extend perpendicularly to a main plane or main surface or main face of the balance pan 27. Specifically, the wafer support pins 29 extend perpendicularly to a main plane or main surface or main face of the balance pan 27 that faces the semiconductor wafer 7 when the semiconductor wafer 7 is loaded on the balance pan 27.

In this embodiment the balance pan 27 comprises three wafer support pins 29 (exactly or only three wafer support pins 29). Of course, in other embodiments there may be a different number of the wafer support pins 29. For example, in other embodiments there may be three or more of the wafer support pins 29.

The wafer support pins 29 are configured to contact an underside of a semiconductor wafer 7 loaded on the balance pan 27 to support the semiconductor wafer 7 during the weight measurement.

As in the comparative example, in this embodiment the load cell 9 is not level. In other words, a weighing axis of the load cell 9 may not be vertical, and/or a top surface and/or a bottom surface of the load cell 9 (and/or a housing enclosing the load cell 9) may not be horizontal.

For example, since the load cell 9 is not level, a shaft of the balance pan 27 connected to the load cell 9 may not be vertical, and therefore a main plane or main surface or main face of the balance pan 27 may not be level or horizontal.

Since the load cell 9 is not level, the balance pan 27 coupled or connected to the load cell 9 is also not level. In other words, a main plane or main surface or main face of the balance pan 27 that faces the semiconductor wafer 7 when the semiconductor wafer 7 is loaded on the balance pan 27 is not level or not horizontal.

However, in this embodiment the wafer support pins 29 include at least two different lengths of wafer support pin 29. In other words, the distances by which the wafer support pins 29 extend perpendicularly from the main plane or main surface or main face of the balance pan 27 include at least two different distances. For example, each of the wafer support pins 29 may have a different length and extend a different distance perpendicularly from the main plane or main surface or main face of the balance pan 27.

There may be three wafer support pins 29, and each of the three wafer support pins 29 may have a different respective length.

Each of the wafer support pins 29 may have a fixed length. Alternatively, one or more of the wafer support pins 29 may have an adjustable length.

The lengths of the wafer support pins 29 may be configured so that tops of the wafer support pins 29 are approximately or substantially arranged in a horizontal plane, or an approximately horizontal plane (for example a plane inclined by less than 5 degrees to horizontal), or a plane that is more level and/or closer to horizontal than a main plane or main surface or main face of the balance pan 27.

A plane formed by tops of the wafer support pins 29 (or a best fit plane fitted to tops of the wafer support pins 29) may be more level/closer to level (or horizontal) than a plane formed by bottoms of the wafer support pins 29 or a main plane or main surface or main face of the balance pan 27.

The different length wafer support pins 29 may support the wafer 7 in a more level and/or more horizontal orientation that a case where the wafer support pins 29 all have the same length.

Therefore, when the semiconductor wafer 7 is loaded on the weighing device 25, the semiconductor wafer is closer to level or closer to horizontal than in the comparative example.

In general, the lengths of the wafer support pins 29 may be configured and/or set and/or selected to support the semiconductor wafer 7 in a more level (or horizontal), or substantially level (or horizontal), or level (or horizontal) orientation (compared to a case where the wafer support pins 29 all have the same length).

Therefore, contact between an edge of the semiconductor wafer 7 and the wafer hangers 17, or with part of the measurement chamber 3, such as the lid 15 or the main body 19, or with another part of the apparatus 1, may be prevented in this embodiment.

In this embodiment, a distance between each of the wafer support pins 29 and a centre of the balance pan 27 (when the balance pan 27 is viewed perpendicularly to a main plane, or main surface or main face of the balance pan 27) is not particularly limited, and may be different to the comparative example.

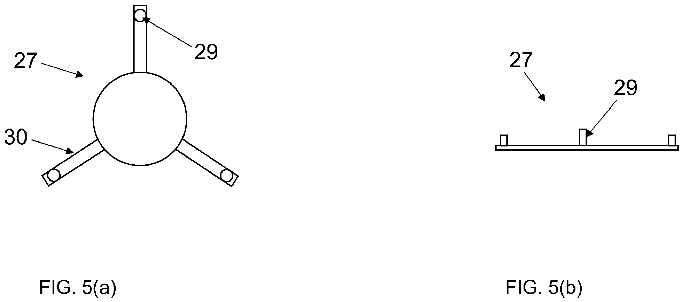

FIGS. 5(a) and 5(b) illustrate a balance pan 27 that can be used in the first embodiment of the present invention. FIG. 5(a) illustrates the balance pan 27 when viewed perpendicularly to a main plane, or main surface or main face of the balance pan 27. FIG. 5(b) illustrates the balance pan 27 when viewed from a side.

As shown in FIGS. 5(a) and 5(b) the balance pan 27 comprises three wafer support pins 29 (exactly or only three wafer support pins 29), which include at least two different lengths of wafer support pin 29. The wafer support pins 29 extend perpendicularly to the main plane, or main surface or main face of the balance pan 27.

The wafer support pins 29 are each connected to a respective arm 30 that extends radially outwards from a central region of the balance pan 27 (when the balance pan 27 is viewed perpendicularly to the main plane, or main surface or main face of the balance pan 27). The wafer support pins 29 extend perpendicularly to the arms 30.

The three wafer support pins 29 may each have a different respective length (so that there are three different lengths of the wafer support pins 29).

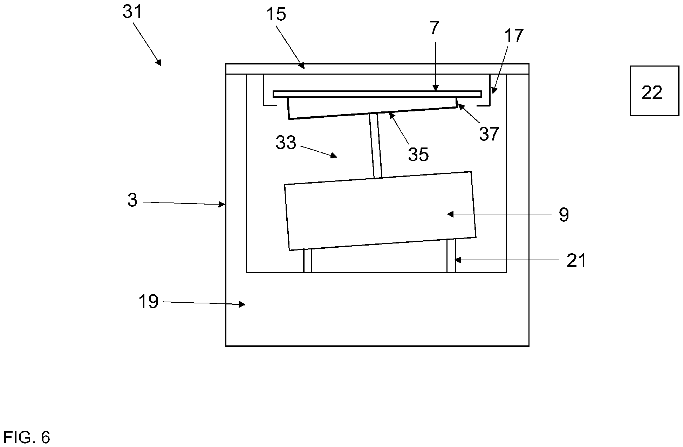

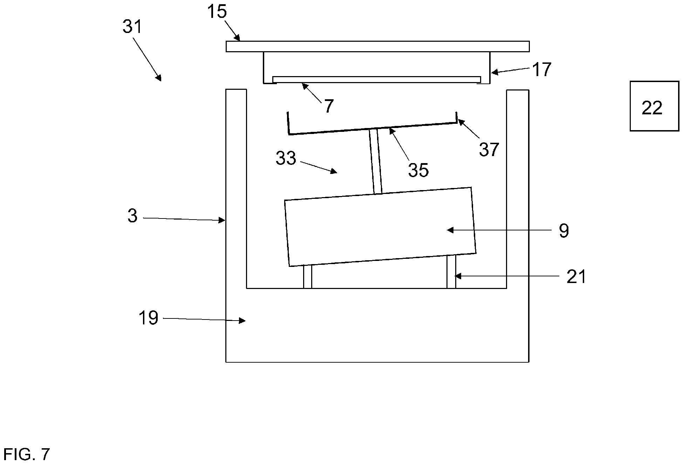

FIGS. 6 and 7 illustrate an apparatus 31 according to a second embodiment of the present invention.

The apparatus 31 is a modified version of the apparatus 1 of the comparative example illustrated in FIGS. 1 and 2 and described above. The apparatus 31 may therefore have any of the features of the comparative example illustrated in FIGS. 1 and 2 and/or described above, unless incompatible with and/or replaced by the modifications described below. Corresponding features are indicated using the same reference numbers in FIG. 6 and 7.

In particular, as described below, the apparatus 31 differs from the apparatus 1 of the comparative example in that the apparatus 31 has a balance pan 35 that is different to the balance pan 11 of the apparatus 1. Any (one, or more than one, or all) of the other features of the apparatus 31 may be the same as in the apparatus 1 of the comparative example.

In particular, in the apparatus 31 the weighing device 5 of the apparatus 1 of the comparative example is replaced with a weighing device 33 having a balance pan 35 that is different to the balance pan 11 of the weighing device 5. Any (one, or more than one, or all) of the other features of the weighing device 33 may be the same as in the weighing device 5 of the apparatus 1. For example, the weighing device 33 includes the same load cell 9 as the weighing device 5 and may include the same plurality of legs 21 as the weighing device 5.

The balance pan 35 comprises a plurality of wafer support pins 37. The wafer support pins 37 extend perpendicularly to a main plane or main surface or main face of the balance pan 35. Specifically, the wafer support pins 37 extend perpendicularly to a main plane or main surface or main face of the balance pan 35 that faces the semiconductor wafer 7 when the semiconductor wafer 7 is loaded on the balance pan 35.

In this embodiment the balance pan 35 comprises three wafer support pins 37 (exactly or only three wafer support pins 37). Of course, in other embodiments there may be a different number of the wafer support pins 37. For example, in other embodiments there may be three or more wafer support pins 37.

The wafer support pins 37 are configured to contact an underside of a semiconductor wafer 7 loaded on the balance pan 35 to support the semiconductor wafer 7 during the weight measurement.

As in the comparative example, in this embodiment the load cell 9 is not level. In other words, a weighing axis of the load cell 9 may not be vertical, and/or a top surface and/or a bottom surface of the load cell 9 (and/or a housing enclosing the load cell 9) may not be horizontal.

Since the load cell 9 is not level, the balance pan 35 coupled or connected to the load cell 9 is also not level. In other words, a main plane or main surface or main face of the balance pan 35 that faces the semiconductor wafer 7 when the semiconductor wafer 7 is loaded on the balance pan 35 is not level or not horizontal.

For example, since the load cell 9 is not level, a shaft of the balance pan 35 connected to the load cell 9 may not be vertical, and therefore a main plane or main surface or main face of the balance pan 35 may not be level or not be horizontal.

However, in this embodiment the wafer support pins 37 include at least two different lengths of wafer support pin 37. In other words, the distances by which the wafer support pins 37 extend perpendicularly from the main plane or main surface or main face of the balance pan 35 include at least two different distances. For example, each of the wafer support pins 37 may have a different length and extend a different distance perpendicularly from the main plane or main surface or main face of the balance pan 35.

There may be three wafer support pins 37, and each of the three wafer support pins 37 may have a different respective length.

Each of the wafer support pins 37 may have a fixed length. Alternatively, one or more of the wafer support pins 37 may have an adjustable length.

The lengths of the wafer support pins 37 may be configured so that tops of the wafer support pins 37 are approximately or substantially arranged in a horizontal plane, or an approximately horizontal plane (for example a plane inclined by less than 5 degrees to horizontal), or a plane that is more level and/or closer to horizontal than a main plane or main surface or main face of the balance pan 35.

A plane formed by tops of the wafer support pins 37 (or a best fit plane fitted to tops of the wafer support pins 37) may be more level/closer to level (or horizontal) than a plane formed by bottoms of the wafer support pins 37 or a main plane or main surface or main face of the balance pan 35.

The different length wafer support pins 37 may support the wafer 7 in a more level and/or more horizontal orientation that a case where the wafer support pins 37 all have the same length.

Therefore, when the semiconductor wafer 7 is loaded on the weighing device 33, the semiconductor wafer 7 is closer to level or closer to horizontal than in the comparative example.

In general, the lengths of the wafer support pins 37 may be configured and/or set and/or selected to support the semiconductor wafer 7 in a more level (or horizontal), or substantially level (or horizontal), or level (or horizontal) orientation (compared to a case where the wafer support pins all have the same length).

Therefore, contact between an edge of the semiconductor wafer 7 and the wafer hangers 17, or with part of the measurement chamber 3, such as the lid 15 or the main body 19, or with another part of the apparatus 1, may be prevented in this embodiment.

In addition, in this embodiment the balance pan 35 is configured so that the wafer support pins 37 contact the underside of the wafer 7 close to an edge (e.g. outer circumferential edge or peripheral edge) of the semiconductor wafer 7, or closer to the edge of the semiconductor wafer 7 that has been the case previously.

For example, the balance pan 35 may be configured so that each of the wafer support pins 37 contacts the underside of the semiconductor wafer 7 less than or equal to 100 mm, or 90 mm, or 80 mm, or 75 mm, or 70 mm, or 60 mm, or 50 mm, or 40 mm, or 30 mm, or 20 mm, or 10 mm from the edge of the semiconductor wafer 7 (for a wafer with a 300 mm diameter).

In practice, semiconductor wafers are often not flat. For example, a semiconductor wafer may have a curved or bowed shape. When the semiconductor wafer is supported close to a middle of the semiconductor wafer, as in the comparative example discussed above, this can introduce considerable uncertainty regarding the position of the edge of the semiconductor wafer. As discussed above, deviations between the position of the edge of the semiconductor wafer 7 that would be expected if the semiconductor wafer 7 was level or was horizontal and the actual position of the edge of the semiconductor wafer 7 can cause problems that can lead to the weight measurement performed by the weighing device being incorrect.

In this embodiment, the semiconductor wafer 7 is supported close to its edge. Therefore, the position of the edge of the semiconductor wafer 7 is controlled and/or clearly defined, even where the semiconductor wafer 7 is curved or bowed. This can prevent or reduce the problems discussed above.

As mentioned above, one problem that may occur when there is a significant deviation between the position of the edge of the semiconductor wafer 7 that would be expected if the semiconductor wafer 7 was level or was horizontal and the actual position of the edge of the semiconductor wafer 7 is that the edge of the semiconductor wafer 7 comes into contact with one or more of the wafer hangers 17 while the semiconductor wafer 7 is loaded on the balance pan 11. This means that part of the weight of the semiconductor wafer 7 will be supported by one or more of the wafer hangers 17, and that the weight measurement will therefore be incorrect.

Therefore, in this embodiment the wafer support pins 37 may be configured to contact the underside of the semiconductor wafer 7 (when the semiconductor wafer 7 is supported by the balance pan 35) close to the positions where the wafer hangers 17 contact the underside of the semiconductor wafer 7 (when the semiconductor wafer 7 is supported by the wafer hangers 17). Therefore, the position of the edge of the semiconductor wafer 7 is controlled and/or clearly defined at the locations of the wafer hangers 17, so that contact between the edge of the semiconductor wafer 7 and the wafer hangers 17 while the semiconductor wafer 7 is loaded on the balance pan 35 can be reduced or prevented.

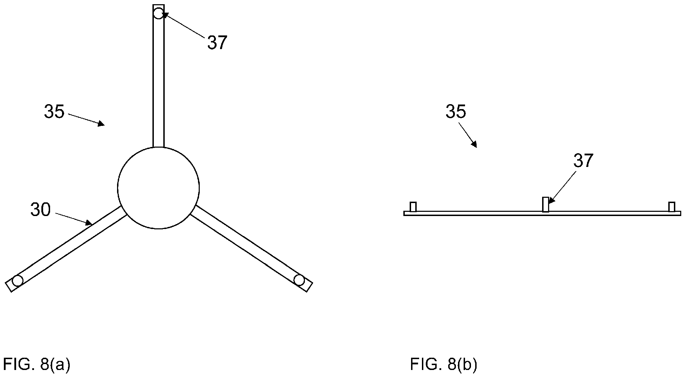

FIGS. 8(a) and 8(b) illustrate a balance pan 35 that can be used in the second embodiment of the present invention. FIG. 8(a) illustrates the balance pan 27 when viewed perpendicularly to a main plane, or main surface or main face of the balance pan 27. FIG. 8(b) illustrates the balance pan 27 when viewed from a side.

As shown in FIGS. 8(a) and 8(b) the balance pan 35 comprises three wafer support pins 37 (exactly or only three wafer support pins 37), which include at least two different lengths of wafer support pin 37. The wafer support pins 37 extend perpendicularly to the main plane, or main surface or main face of the balance pan 35.

The wafer support pins 37 are each connected to a respective arm 30 that extends radially outwards from a central region of the balance pan 35 (when the balance pan 35 is viewed perpendicularly to the main plane, or main surface or main face of the balance pan 35). The wafer support pins 37 extend perpendicularly to the arms 30.

The three wafer support pins 37 may each have a different respective length (so that there are three different lengths of the wafer support pins 37).

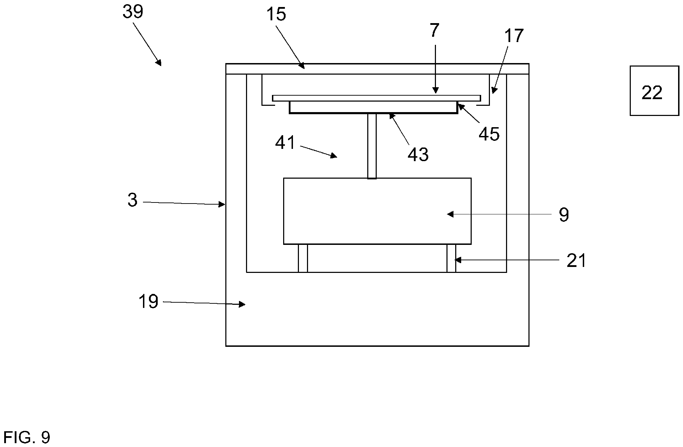

FIG. 9 illustrates an apparatus 39 according to a third embodiment of the present invention. The apparatus 39 is a modified version of the apparatus 1 of the comparative example illustrated in FIGS. 1 and 2 and described above. The apparatus 39 may therefore have any of the features of the comparative example illustrated in FIGS. 1 and 2 and/or described above, unless incompatible with and/or replaced by the modifications described below.

In particular, as described below, the apparatus 39 differs from the apparatus 1 of the comparative example in that the apparatus 39 has a balance pan 43 that is different to the balance pan 11 of the apparatus 1. Any (one, or more than one, or all) of the other features of the apparatus 39 may be the same as in the apparatus 1 of the comparative example. These features are not repeated here for conciseness. Corresponding features are indicated using the same reference numbers in FIG. 9.

In particular, in the apparatus 39 the weighing device 5 of the apparatus 1 of the comparative example is replaced with a weighing device 41 having a balance pan 43 that is different to the balance pan 11 of the weighing device 5. Any (one, or more than one, or all) of the other features of the weighing device 41 may be the same as in the weighing device 5 of the apparatus 1. For example, the weighing device 41 includes the same load cell 9 as the weighing device 5 and may include the same plurality of legs 21 as the weighing device 5.

The balance pan 43 comprises a plurality of wafer support pins 45. The wafer support pins 45 extend perpendicularly to a main plane or main surface or main face of the balance pan 43. Specifically, the wafer support pins 45 extend perpendicularly to a main plane or main surface or main face of the balance pan 43 that faces the semiconductor wafer 7 when the semiconductor wafer 7 is loaded on the balance pan 43.

In this embodiment the balance pan 43 comprises three wafer support pins 45 (exactly or only three wafer support pins 45). Of course, in other embodiments there may be a different number of the wafer support pins 45. For example, in other embodiments there may be three or more wafer support pins 45.

The wafer support pins 45 are configured to contact an underside of a semiconductor wafer 7 loaded on the balance pan 43 to support the semiconductor wafer 7 during the weight measurement.

In this embodiment, the wafer support pins 45 all have the same length (or substantially the same length).

For example, in this embodiment the load cell 9 may be level, such that the balance pan 43 is level.

As with the second embodiment, in this embodiment the balance pan 43 is configured so that the wafer support pins 45 contact the underside of the wafer 7 close to an edge (e.g. outer circumferential edge or peripheral edge) of the semiconductor wafer 7.

For example, the balance pan 43 may be configured so that each of the wafer support pins 45 contacts the underside of the semiconductor wafer 7 less than or equal to 100 mm, or 90 mm, or 80 mm, or 70 mm, or 60 mm, or 50 mm, or 40 mm, or 30 mm, or 20 mm, or 10 mm from the edge of the semiconductor wafer (for a wafer with a 300 mm diameter).

For example, the balance pan 43 may be configured so that each of the wafer support pins 45 are located at least 50 mm, or at least 60 mm, or at least 70 mm, or at least 80 mm, or at least 90 mm, or at least 100 mm, or at least 110 mm, or at least 120 mm, or at least 130 mm, or at least 140 mm, from a centre of the support (for a wafer having a diameter of 300 mm) .

In addition, as with the second embodiment, in this embodiment the wafer support pins 45 may be configured to contact the underside of the semiconductor wafer 7 close to the positions where the wafer hangers 17 contact the underside of the semiconductor wafer 7 when the semiconductor wafer 7 is supported by the wafer hangers 17.

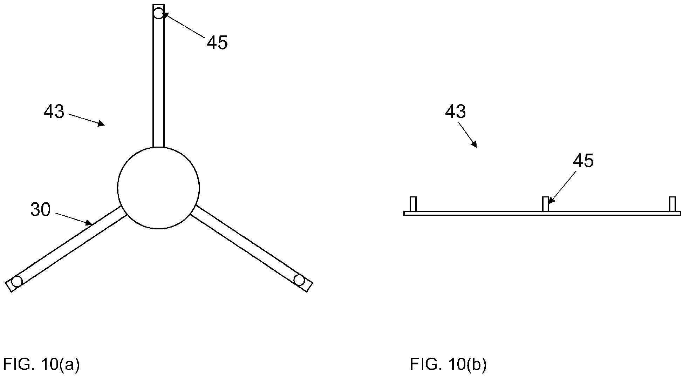

FIGS. 10(a) and 10(b) illustrate a balance pan 43 that can be used in the third embodiment of the present invention. FIG. 10(a) illustrates the balance pan 43 when viewed perpendicularly to a main plane, or main surface or main face of the balance pan 43. FIG. 10(b) illustrates the balance pan 43 when viewed from a side.

As shown in FIGS. 10(a) and 10(b) the balance pan 43 comprises three wafer support pins 45 (exactly or only three wafer support pins 45), which all have the same length. The wafer support pins 45 extend perpendicularly to the main plane, or main surface or main face of the balance pan 43.

The wafer support pins 45 are each connected to a respective arm 30 that extends radially outwards from a central region of the balance pan 43 (when the balance pan 43 is viewed perpendicularly to the main plane, or main surface or main face of the balance pan 43). The wafer support pins 45 extend perpendicularly to the arms 30.

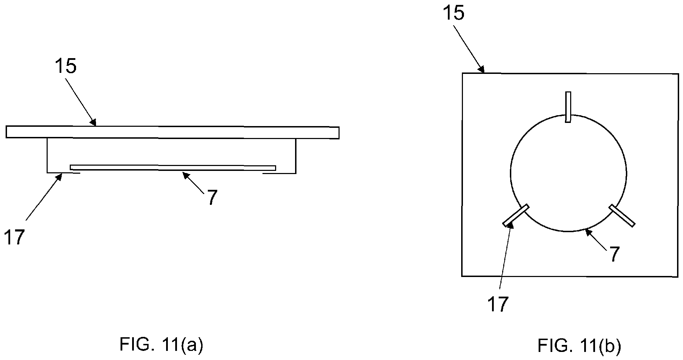

FIGS. 11(a) and 11(b) illustrate a lid for a measurement chamber that can be used in embodiments of the present invention. The lid illustrated in FIGS. 11(a) and 11(b) may correspond to the lid in any of the embodiments described above, for example the lid 15 in any of FIGS. 1 to 10.

The lid illustrated in FIGS. 11(a) and 11(b) may be used as the lid in any of the embodiments described above.

As illustrated in FIGS. 11(a) and 11(b), the lid 15 comprises three wafer hangers 17 (exactly or only three wafer hangers 17) for supporting the wafer 7. The lid 15 and the wafer hangers 17 may have any of the features of the lid 15 and the wafer hangers 17 described above.

The three wafer hangers 17 are evenly distributed around the circumference of the wafer 7, for example so as to form an equilateral triangle between the three wafer hangers 17.

In particular, contact points of the three wafer hangers 17 for contacting and supporting the wafer 7 may be evenly distributed around the circumference of the wafer 7, for example so as to form an equilateral triangle between the contact points of the three wafer hangers 17

The wafer hangers 17 are substantially L-shaped and extend inwards relative to the wafer 7.

In particular, in this embodiment each of the wafer hangers 17 comprises a first portion that extends substantially vertically downwards from the underside of the lid 15, and a second portion that extends substantially horizontally and radially inwards relative to the wafer 7 from the first portion.

Of course, in other embodiments the second portion of one or more of the wafer hangers 17 may not extend radially inwards. For example, the second portion of one or more of the wafer hangers 17 may be at an acute angle to the radial direction of the wafer.

In one embodiment, the second portion of a first one of the wafer hangers 17 may be in a radial direction of the wafer, and the second portions of a second and third ones of the wafer hangers 17 may be perpendicular to the second portion of the first one of the wafer hangers 17.

The second portions of the wafer hangers 17 are sufficiently long that the wafer 7 can be inserted between any two of the wafer hangers 17 from the side (i.e. laterally) and then lowered onto the second portions of the wafer hangers 17. For example, the wafer 7 may be supported from underneath by an end effector or other wafer supporter and the end effector may be used to position the wafer 7 between the wafer hangers 17 and to lower the wafer 7 onto the second portions of the wafer hangers 17.

The wafer hangers 17 may each comprise a protrusion, for example a bump or pin, for contacting the underside of the wafer 7 when the wafer 7 is supported by the wafer hanger 17. This may minimise contact between the wafer 7 and the wafer hangers 17, and therefore minimise contamination of the wafer 7. For example, the protrusion may be located on an upper side of the second portions of the wafer hangers 17.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a, " "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. An apparatus (1, 23, 31, 39) comprising:
a measurement chamber (3), wherein the measurement chamber has a removable lid (15); and
a plurality of wafer support elements (17) for supporting a wafer (7) from beneath, wherein the plurality of wafer support elements are provided on the lid.

2. The apparatus according to claim 1, wherein:
the wafer support elements are provided on an underside of the lid; and/or
the wafer support elements are wafer hangers; and/or
the wafer support elements are configured to suspend the wafer beneath the underside of the lid; and/or
there are exactly three of the wafer support elements, optionally wherein contact points of the three wafer support elements are configured to be evenly spaced around a circumference of the wafer when the wafer is supported by the three wafer support elements; and/or
each of the plurality of wafer support elements is substantially L-shaped; and/or
each of the plurality of wafer support elements is configured to extend inwards relative to a wafer supported by the plurality of wafer support elements.

3. The apparatus according to claim 1 or 2, wherein the lid is a top surface of the measurement chamber.

4. The apparatus according to any one of the preceding claims, wherein the lid is movable vertically upwards relative to a main body of the measurement chamber to remove the lid from the main body of the measurement chamber, and movable vertically downwards relative to the main body of the measurement chamber to position the lid on the main body of the measurement chamber, optionally wherein the apparatus comprises one or more actuators connected or coupled to the lid and operable to move the lid relative to the main body of the measurement chamber.

5. The apparatus according to any one of the preceding claims, wherein:
the apparatus comprises a weighing device (5, 25, 31, 41) for performing a weight measurement on a wafer; and
the weighing device is inside the measurement chamber,
optionally wherein the apparatus is configured so that the wafer is loaded onto the weighing device from the wafer support elements when the lid is positioned on the measurement chamber.

6. The apparatus according to claim 5, wherein:
the weighing device comprises a support (11, 27, 35, 43) for supporting the wafer during the weight measurement; and
the apparatus is configured so that the wafer is loaded onto the support from the wafer support elements when the lid is positioned on the measurement chamber,
optionally wherein the support comprises a plurality of contact elements (13, 29, 37, 45) configured to contact an underside of the wafer to support the wafer during the weight measurement, and further optionally wherein when the lid is positioned on the measurement chamber, contact points of the contact elements are vertically higher than contact points of the wafer support elements.

7. The apparatus according to any one of the preceding claims, wherein the apparatus comprises a seal that is located between the lid and the measurement chamber when the lid is positioned on the measurement chamber.

8. The apparatus according to claim 5 or 6, wherein the weighing device is for performing a weight measurement on a wafer having a specific diameter D, the weighing device comprising a support for supporting the wafer during the weight measurement, wherein:
the support comprises a plurality of contact elements configured to contact an underside of the wafer less than or equal to a distance of D/3, or D/4, or D/5, or D/6, or D/7, or D/8, or D/9, or D/10, or D/11, or D/12, or D/13, or D/14, or D/15, or D/16, or D/17, or D/18, or D/19, or D/20 from an edge of the wafer, to support the wafer during the weight measurement.

9. The apparatus according to claim 8, wherein
the plurality of contact elements comprise pins; and/or
the weighing device is for performing a weight measurement on a wafer having a diameter of 200 mm, or 300 mm, or 450 mm; and/or
the plurality of contact elements comprise two or more different lengths of contact element, optionally wherein the plurality of contact elements comprise two or more different lengths of contact element so as to support the wafer in a more level orientation; and/or
one or more of the plurality of contact elements has an adjustable length.

10. The apparatus according to claim 8 or 9, wherein:
the plurality of wafer support elements are for supporting the wafer from beneath while the wafer is being loaded onto the support; and
a contact element of the plurality of contact elements is configured to contact the underside of the wafer less than or equal to 50 mm from a position where a wafer support element of the plurality of wafer support elements is configured to contact the underside of the wafer,
optionally wherein:
the contact element is configured to contact the underside of the wafer less than or equal to 40 mm, or 30 mm, or 20 mm, or 10 mm, from the position where the wafer support element is configured to contact the underside of the wafer; and/or
each of the plurality of contact elements is configured to contact the underside of the wafer less than or equal to 50 mm, or 40 mm, or 30 mm, or 20 mm, or 10 mm from a position where a wafer support element of the plurality of wafer support elements is configured to contact the underside of the wafer.

11. The apparatus according to claim 5 or 6, wherein the weighing device comprises a support for supporting the wafer during the weight measurement, wherein:
the support comprises a plurality of contact elements located at least 50 mm from a centre of the support and configured to contact an underside of the wafer to support the wafer during the weight measurement,
optionally wherein the plurality of contact elements are located at least 60 mm, or at least 70 mm, or at least 75 mm, or at least 80 mm, or at least 90 mm, or at least 100 mm, or at least 110 mm, or at least 120 mm, or at least 130 mm, or at least 140 mm, from the centre of the support.

12. The apparatus according to claim 5 or 6, wherein:
the weighing device comprises a support for supporting the wafer during the weight measurement, wherein the support comprises a plurality of contact elements configured to contact an underside of the wafer to support the wafer during the weight measurement;
the plurality of wafer support elements are for supporting the wafer from beneath while the wafer is being loaded onto the support; and
a contact element of the plurality of contact elements is configured to contact the underside of the wafer less than or equal to 50 mm from a position where a wafer support element of the plurality of wafer support elements is configured to contact the underside of the wafer,
optionally wherein:
the contact element is configured to contact the underside of the wafer less than or equal to 40 mm, or 30 mm, or 20 mm, or 10 mm, from the position where the wafer support element is configured to contact the underside of the wafer; and/or
each of the plurality of contact elements is configured to contact the underside of the wafer less than or equal to 50 mm, or 40 mm, or 30 mm, or 20 mm, or 10 mm from a position where a wafer support element of the plurality of wafer support elements is configured to contact the underside of the wafer.

13. The apparatus according to claim 12, wherein:
the plurality of contact elements comprise pins; and/or
the plurality of contact elements comprise two or more different lengths of contact element, optionally wherein the plurality of contact elements comprise two or more different lengths of contact element so as to support the wafer in a more level orientation during the weight measurement; and/or
one or more of the plurality of contact elements has an adjustable length.

14. The apparatus according to claim 12 or 13, wherein:
the weighing device is for performing a weight measurement on a wafer having a specific diameter D, and one of more of the plurality of contact elements is configured to contact an underside of the wafer less than or equal to a distance of D/3, or D/4, or D/5, or D/6, or D/7, or D/8, or D/9, or D/10, or D/11, or D/12, or D/13, or D/14, or D/15, or D/16, or D/17, or D/18, or D/19, or D/20 from an edge of the wafer; and/or
one or more of the plurality of contact elements is located at least 50 mm, or at least 60 mm, or at least 70 mm, or at least 75 mm, or at least 80 mm, or at least 90 mm, or at least 100 mm, or at least 110 mm, or at least 120 mm, or at least 130 mm, or at least 140 mm from a centre of the support.

15. The apparatus according to claim 5 or 6, wherein the weighing device comprises a support for supporting the wafer during the weight measurement, wherein:
the support comprises a plurality of contact elements configured to contact an underside of the wafer to support the wafer during the weight measurement; and
the plurality of contact elements include two or more different lengths of contact element,
optionally wherein:
the plurality of contact elements comprise two or more different lengths of contact element so as to support the wafer in a more level orientation during the weight measurement; and/or
at least one of the plurality of contact elements has an adjustable length.

## Patentansprüche

1. Vorrichtung (1, 23, 31, 39), die Folgendes umfasst:
eine Messkammer (3), wobei die Messkammer einen entfernbaren Deckel (15) aufweist; und
eine Vielzahl von Waferträgerelementen (17) zum Stützen eines Wafers (7) von unten, wobei die Vielzahl von Waferträgerelementen auf dem Deckel bereitgestellt ist.

2. Vorrichtung nach Anspruch 1, wobei:
die Waferträgerelemente auf einer Unterseite des Deckels bereitgestellt sind; und/oder
die Waferträgerelemente Waferhalterungen sind; und/oder
die Waferträgerelemente dazu ausgelegt sind, den Wafer unterhalb der Unterseite des Deckels aufzuhängen; und/oder
genau drei der Waferträgerelemente existieren, wobei gegebenenfalls Kontaktpunkte der drei Waferträgerelemente dazu ausgelegt sind, gleichmäßig um einen Umfang des Wafers beabstandet zu sein, wenn der Wafer von den drei Waferträgerelementen gestützt wird; und/oder
jedes aus der Vielzahl von Waferträgerelementen im Wesentlichen L-förmig ist; und/oder
jedes aus der Vielzahl von Waferträgerelementen dazu ausgelegt ist, sich relativ zu einem von der Vielzahl von Waferträgerelementen gestützten Wafer nach innen zu erstrecken.

3. Vorrichtung nach Anspruch 1 oder 2, wobei der Deckel eine Oberseite der Messkammer ist.

4. Vorrichtung nach einem der vorangegangenen Ansprüche, wobei der Deckel relativ zu einem Hauptkörper der Messkammer vertikal nach oben bewegbar ist, um den Deckel von dem Hauptkörper der Messkammer zu entfernen, und relativ zu dem Hauptkörper der Messkammer vertikal nach unten bewegbar ist, um den Deckel auf dem Hauptkörper der Messkammer zu positionieren, wobei die Vorrichtung gegebenenfalls einen oder mehrere Aktuatoren umfasst, die mit dem Deckel verbunden oder gekoppelt sind, und betätigbar sind, um den Deckel relativ zum Hauptkörper der Messkammer zu bewegen.

5. Vorrichtung nach einem der vorangegangenen Ansprüche, wobei:
die Vorrichtung eine Wiegevorrichtung (5, 25, 31, 41) zum Durchführen einer Gewichtsmessung an einem Wafer umfasst; und
die Wiegevorrichtung sich innerhalb der Messkammer befindet, wobei die Vorrichtung gegebenenfalls derart ausgelegt ist, dass der Wafer von den Waferträgerelementen auf die Wiegevorrichtung geladen wird, wenn der Deckel auf der Messkammer positioniert ist.

6. Vorrichtung nach Anspruch 5, wobei:
die Wiegevorrichtung einen Träger (11, 27, 35, 43) zum Stützen des Wafers während der Gewichtsmessung umfasst; und
die Vorrichtung derart ausgelegt ist, dass der Wafer von den Waferträgerelementen auf den Träger geladen wird, wenn der Deckel auf der Messkammer positioniert ist,
wobei gegebenenfalls der Träger eine Vielzahl von Kontaktelementen (13, 29, 37, 45) umfasst, die dazu ausgelegt sind, eine Unterseite des Wafers während der Gewichtsmessung zu berühren, und wobei gegebenenfalls ferner, wenn der Deckel auf der Messkammer positioniert ist, Kontaktpunkte der Kontaktelemente vertikal höher sind als Kontaktpunkte der Waferträgerelemente.

7. Vorrichtung nach einem der vorangegangenen Ansprüche, wobei die Vorrichtung eine Dichtung umfasst, die zwischen dem Deckel und der Messkammer angeordnet ist, wenn der Deckel auf der Messkammer positioniert ist.

8. Vorrichtung nach Anspruch 5 oder 6, wobei die Wiegevorrichtung dem Durchführen einer Gewichtsmessung an einem Wafer mit einem spezifischen Durchmesser D dient, wobei die Wiegevorrichtung einen Träger zum Stützen des Wafers während der Gewichtsmessung umfasst, wobei:
der Träger eine Vielzahl von Kontaktelementen umfasst, die dazu ausgelegt sind, eine Unterseite des Wafers in einem Abstand von weniger als oder gleich D/3 oder D/4 oder D/5 oder D/6 oder D/7 oder D/8 oder D/9 oder D/10 oder D/11 oder D/12 oder D/13 oder D/14 oder D/15 oder D/16 oder D/17 oder D/18 oder D/19 oder D/20 von einer Kante des Wafers zu berühren, um den Wafer während der Gewichtsmessung zu stützen.

9. Vorrichtung nach Anspruch 8, wobei
die Vielzahl von Kontaktelementen Stifte umfasst; und/oder
die Wiegevorrichtung dem Durchführen einer Gewichtsmessung an einem Wafer mit einem Durchmesser von 200 mm, oder 300 mm oder 450 mm dient; und/oder
die Vielzahl von Kontaktelementen zwei oder mehrere unterschiedliche Längen von Kontaktelement aufweist, wobei die Vielzahl von Kontaktelementen gegebenenfalls zwei oder mehrere verschiedene Längen von Kontaktelement umfasst, um den Wafer in einer Ausrichtung auf mehreren Ebenen zu stützen; und/oder
eines oder mehrere aus der Vielzahl von Kontaktelementen eine einstellbare Länge aufweist/aufweisen.

10. Vorrichtung nach Anspruch 8 oder 9, wobei:
die Vielzahl von Waferträgerelementen dem Stützen des Wafers von unten, während der Wafer auf den Träger geladen wird, dient; und
ein Kontaktelement aus der Vielzahl von Kontaktelementen dazu ausgelegt ist, die Unterseite des Wafers weniger als oder gleich 50 mm von einer Position zu berühren, in der ein Waferträgerelement aus der Vielzahl von Waferträgerelementen dazu ausgelegt ist, die Unterseite des Wafers zu berühren,
wobei gegebenenfalls:
das Kontaktelement dazu ausgelegt ist, die Unterseite des Wafers weniger als oder gleich 40 mm, oder 30 mm, oder 20 mm oder 10 mm von der Position zu berühren, in der das Waferträgerelement dazu ausgelegt ist, die Unterseite des Wafers zu berühren; und/oder
jedes aus der Vielzahl von Kontaktelementen dazu ausgelegt ist, die Unterseite des Wafers weniger als oder gleich 50 mm, oder 40 mm, oder 30 mm, oder 20 mm oder 10 mm von einer Position zu berühren, in der ein Waferträgerelement aus der Vielzahl von Waferträgerelementen dazu ausgelegt ist, die Unterseite des Wafers zu berühren.

11. Vorrichtung nach Anspruch 5 oder 6, wobei die Wiegevorrichtung einen Träger zum Stützen des Wafers während der Gewichtsmessung umfasst, wobei:
der Träger eine Vielzahl von Kontaktelementen umfasst, die zumindest 50 mm von einem Mittelpunkt des Trägers entfernt und dazu ausgelegt ist, eine Unterseite des Wafers zu berühren, um den Wafer während der Gewichtsmessung zu stützen,
wobei die Vielzahl von Kontaktelementen gegebenenfalls zumindest 60 mm, oder zumindest 70 mm, oder zumindest 75 mm, oder zumindest 80 mm, oder zumindest 90 mm, oder zumindest 100 mm, oder zumindest 110 mm, oder zumindest 120 mm, oder zumindest 130 mm oder zumindest 140 mm vom Mittelpunkt des Trägers angeordnet ist.

12. Vorrichtung nach Anspruch 5 oder 6, wobei:
die Wiegevorrichtung einen Träger zum Stützen des Wafers während der Gewichtsmessung umfasst, wobei der Träger eine Vielzahl von Kontaktelementen umfasst, die dazu ausgelegt sind, eine Unterseite des Wafers zu berühren, um den Wafer während der Gewichtsmessung zu stützen;
die Vielzahl von Waferträgerelementen dem Stützen des Wafers von unten, während der Wafer auf den Träger geladen wird, dient; und
ein Kontaktelement der Vielzahl von Kontaktelementen ausgelegt ist, die Unterseite des Wafers weniger als oder gleich 50 mm von einer Position zu berühren, in der ein Waferträgerelement der Vielzahl von Waferträgerelementen ausgelegt ist, um die Unterseite des Wafers zu berühren,
wobei gegebenenfalls:
das Kontaktelement dazu ausgelegt ist, die Unterseite des Wafers weniger als oder gleich 40 mm, oder 30 mm, oder 20 mm oder 10 mm von der Position zu berühren, in der das Waferträgerelement dazu ausgelegt ist, die Unterseite des Wafers zu berühren; und/oder
jedes aus der Vielzahl von Kontaktelementen dazu ausgelegt ist, die Unterseite des Wafers weniger als oder gleich 50 mm, oder 40 mm, oder 30 mm, oder 20 mm oder 10 mm von einer Position zu berühren, in der ein Waferträgerelement aus der Vielzahl von Waferträgerelementen dazu ausgelegt ist, die Unterseite des Wafers zu berühren.

13. Vorrichtung nach Anspruch 12, wobei:
die Vielzahl von Kontaktelementen Stifte umfasst; und/oder
die Vielzahl von Kontaktelementen zwei oder mehrere unterschiedliche Längen von Kontaktelementen aufweisen, wobei die Vielzahl von Kontaktelementen gegebenenfalls zwei oder mehrere unterschiedliche Längen von Kontaktelement umfasst, um den Wafer in einer Ausrichtung auf mehreren Ebenen während der Gewichtsmessung zu stützen; und/oder
eines oder mehrere aus der Vielzahl von Kontaktelementen eine einstellbare Länge aufweist/aufweisen.

14. Vorrichtung nach Anspruch 12 oder 13, wobei:
die Wiegevorrichtung dem Durchführen einer Gewichtsmessung an einem Wafer mit einem spezifischen Durchmesser D dient, und eines oder mehrere aus der Vielzahl von Kontaktelementen dazu ausgelegt ist/sind, eine Unterseite des Wafers in einem Abstand von weniger als oder gleich D/3 oder D/4 oder D/5 oder D/6 oder D/7 oder D/8 oder D/9 oder D/10 oder D/11 oder D/12 oder D/13 oder D/14 oder D/15 oder D/16 oder D/17 oder D/18 oder D/19 oder D/20 von einer Kante des Wafers zu berühren; und/oder
eines oder mehrere aus der Vielzahl von Kontaktelementen zumindest 50mm, oder zumindest 60 mm, oder zumindest 70 mm, oder zumindest 75 mm, oder zumindest 80 mm, oder zumindest 90 mm, oder zumindest 100 mm, oder zumindest 110 mm, oder zumindest 120 mm, oder zumindest 130 mm oder zumindest 140 mm von einem Mittelpunkt des Trägers angeordnet ist/sind.

15. Vorrichtung nach Anspruch 5 oder 6, wobei die Wiegevorrichtung einen Träger zum Stützen des Wafers während der Gewichtsmessung umfasst, wobei:
der Träger eine Vielzahl von Kontaktelementen umfasst, die dazu ausgelegt sind, eine Unterseite des Wafers zu berühren, um den Wafer während der Gewichtsmessung zu stützen; und
die Vielzahl von Kontaktelementen zwei oder mehrere unterschiedliche Längen von Kontaktelement aufweisen,
wobei gegebenenfalls:
die Vielzahl von Kontaktelementen zwei oder mehrere unterschiedliche Längen von Kontaktelement umfasst, um den Wafer während der Gewichtsmessung in einer Ausrichtung auf mehreren Ebenen zu stützen; und/oder
zumindest eines aus der Vielzahl von Kontaktelementen eine einstellbare Länge aufweist.

## Revendications

1. Appareil (1, 23, 31, 39) comprenant :
une chambre de mesure (3), dans lequel la chambre de mesure a un couvercle amovible (15) ; et
une pluralité d'éléments de support de tranche (17) pour supporter une tranche (7) de dessous, dans lequel la pluralité d'éléments de support de tranche est prévue sur le couvercle.

2. Appareil selon la revendication 1, dans lequel :
les éléments de support de tranche sont prévus sur une face inférieure du couvercle ; et/ou
les éléments de support de tranche sont des dispositifs de suspension de tranche ; et/ou
les éléments de support de tranche sont configurés pour suspendre la tranche sous la face inférieure du couvercle ; et/ou
il y a exactement trois éléments de support de tranche, facultativement dans lequel les points de contact des trois éléments de support de tranche sont configurés pour être régulièrement espacés autour d'une circonférence de la tranche lorsque la tranche est supportée par les trois éléments de support de tranche ; et/ou
chacun de la pluralité d'éléments de support de tranche est sensiblement en forme de L ; et/ou
chacun de la pluralité d'éléments de support de tranche est configuré pour s'étendre vers l'intérieur par rapport à une tranche supportée par la pluralité d'éléments de support de tranche.

3. Appareil selon la revendication 1 ou 2, dans lequel le couvercle est une surface supérieure de la chambre de mesure.

4. Appareil selon l'une quelconque des revendications précédentes, dans lequel le couvercle est verticalement mobile vers le haut par rapport à un corps principal de la chambre de mesure pour retirer le couvercle du corps principal de la chambre de mesure, et mobile verticalement vers le bas par rapport au corps principal de la chambre de mesure pour positionner le couvercle sur le corps principal de la chambre de mesure, facultativement dans lequel l'appareil comprend un ou plusieurs actionneurs raccordés ou couplés au couvercle et opérationnels pour déplacer le couvercle par rapport au corps principal de la chambre de mesure.

5. Appareil selon l'une quelconque des revendications précédentes, dans lequel :
l'appareil comprend un dispositif de pesage (5, 25, 31, 41) pour réaliser une mesure de poids sur une tranche ; et
le dispositif de pesage est à l'intérieur de la chambre de mesure,
facultativement dans lequel l'appareil est configuré de sorte que la tranche est chargée sur le dispositif de pesage à partir des éléments de support de tranche lorsque le couvercle est positionné sur la chambre de mesure.

6. Appareil selon la revendication 5, dans lequel :
le dispositif de pesage comprend un support (11, 27, 35, 43) pour supporter la tranche pendant la mesure de poids ; et
l'appareil est configuré de sorte que la tranche est chargée sur le support à partir des éléments de support de tranche lorsque le couvercle est positionné sur la chambre de mesure,
facultativement dans lequel le support comprend une pluralité d'éléments de contact (13, 29, 37, 45) configurés pour être en contact avec une face inférieure de la tranche pour supporter la tranche pendant la mesure de poids, et en outre facultativement dans lequel lorsque le couvercle est positionné sur la chambre de mesure, les points de contact des éléments de contact sont verticalement plus hauts que les points de contact des éléments de support de tranche.

7. Appareil selon l'une quelconque des revendications précédentes, dans lequel l'appareil comprend un joint d'étanchéité qui est situé entre le couvercle et la chambre de mesure lorsque le couvercle est positionné sur la chambre de mesure.

8. Appareil selon la revendication 5 ou 6, dans lequel le dispositif de pesage est prévu pour réaliser une mesure de poids sur une tranche ayant un diamètre spécifique D, le dispositif de pesage comprenant un support pour supporter la tranche pendant la mesure de poids, dans lequel :
le support comprend une pluralité d'éléments de contact configurée pour être en contact avec une face inférieure de la tranche selon une valeur inférieure ou égale à une distance de D/3, ou D/4, ou D/5, ou D/6, ou D/7, ou D/8, ou D/9, ou D/10, ou D/11, ou D/12, ou D13, ou D/14, ou D/15, ou D/16, ou D/17, ou D/18, ou D/19, ou D/20 d'un bord de la tranche, pour supporter la tranche pendant la mesure de poids.

9. Appareil selon la revendication 8, dans lequel :
la pluralité d'éléments de contact comprend des broches ; et/ou
le dispositif de pesage est prévu pour réaliser une mesure de poids sur une tranche ayant un diamètre de 200 mm, ou 300 mm ou 450 mm ; et/ou
la pluralité d'éléments de contact comprend deux longueurs différentes ou plus d'élément de contact, facultativement dans lequel la pluralité d'éléments de contact comprend deux longueurs différentes ou plus d'élément de contact afin de supporter la tranche dans une orientation plus plane ; et/ou
un ou plusieurs de la pluralité d'éléments de contact ont une longueur réglable.

10. Appareil selon la revendication 8 ou 9, dans lequel :
la pluralité d'éléments de support de tranche est prévue pour supporter la tranche de dessous alors que la tranche est chargée sur le support ; et
un élément de contact de la pluralité d'éléments de contact est configuré pour être en contact avec la face inférieure de la tranche selon une valeur inférieure ou égale à 50 mm d'une position où un élément de support de tranche de la pluralité d'éléments de support de tranche est configuré pour être en contact avec la face inférieure de la tranche,
facultativement dans lequel :
l'élément de contact est configuré pour être en contact avec la face inférieure de la tranche selon une valeur inférieure ou égale à 40 mm, ou 30 mm, ou 20 mm, ou 10 mm de la position où l'élément de support de tranche est configuré pour être en contact avec la face inférieure de la tranche ; et/ou
chacun de la pluralité d'éléments de contact est configuré pour être en contact avec la face inférieure de la tranche selon une valeur inférieure ou égale à 50 mm, ou 40 mm, ou 30 mm, ou 20 mm, ou 10 mm d'une position où un élément de support de tranche de la pluralité d'éléments de support de tranche est configuré pour être en contact avec la face inférieure de la tranche.

11. Appareil selon la revendication 5 ou 6, dans lequel le dispositif de pesage comprend un support pour supporter la tranche pendant la mesure de poids, dans lequel :
le support comprend une pluralité d'éléments de contact située au moins à 50 mm d'un centre du support et configurée pour être en contact avec une face inférieure de la tranche pour supporter la tranche pendant la mesure de poids,
facultativement, dans lequel la pluralité d'éléments de contact est positionnée au moins à 60 mm, ou au moins à 70 mm, ou au moins à 75 mm, ou au moins à 80 mm, ou au moins à 90 mm, ou au moins à 100 mm, ou au moins à 110 mm, ou au moins à 120 mm, ou au moins à 130 mm, ou au moins à 140 mm du centre du support.

12. Appareil selon la revendication 5 ou 6, dans lequel :
le dispositif de pesage comprend un support pour supporter la tranche pendant la mesure de poids, dans lequel le support comprend une pluralité d'éléments de contact configurée pour être en contact avec une face inférieure de la tranche pour supporter la tranche pendant la mesure de poids ;
la pluralité d'éléments de support de tranche est prévue pour supporter la tranche de dessous, alors que la tranche est chargée sur le support ; et
un élément de contact de la pluralité d'éléments de contact est configuré pour être en contact avec la face inférieure de la tranche selon une valeur inférieure ou égale à 50 mm d'une position où un élément de support de tranche de la pluralité d'éléments de support de tranche est configuré pour être en contact avec la face inférieure de la tranche,
facultativement dans lequel :
l'élément de contact est configuré pour être en contact avec la face inférieure de la tranche selon une valeur inférieure ou égale à 40 mm, ou 30 mm, ou 20 mm, ou 10 mm de la position où l'élément de support de tranche est configuré pour être en contact avec la face inférieure de la tranche ; et/ou
chacun de la pluralité d'éléments de contact est configuré pour être en contact avec la face inférieure de la tranche selon une valeur inférieure ou égale à 50 mm, ou 40 mm, ou 30 mm, ou 20 mm, ou 10 mm d'une position où un élément de support de tranche de la pluralité d'éléments de support de tranche est configuré pour être en contact avec la face inférieure de la tranche.

13. Appareil selon la revendication 12, dans lequel :
la pluralité d'éléments de contact comprend des broches ; et/ou
la pluralité d'éléments de contact comprend deux longueurs différentes ou plus d'élément de contact, facultativement dans lequel la pluralité d'éléments de contact comprend deux longueurs différentes ou plus d'élément de contact pour supporter la tranche dans une orientation plus plane pendant la mesure de poids ; et/ou
un ou plusieurs de la pluralité d'éléments de contact ont une longueur réglable.

14. Appareil selon la revendication 12 ou 13, dans lequel :
le dispositif de pesage est prévu pour réaliser une mesure de poids sur une tranche ayant un diamètre spécifique D, et un ou plusieurs de la pluralité d'éléments de contact est configuré pour être en contact avec une face inférieure de la tranche selon une valeur inférieure ou égale à une distance de D/3, ou D/4, ou D/5, ou D/6, ou D/7, ou D/8, ou D/9, ou D/10, ou D/11, ou D/12, ou D13, ou D/14, ou D/15, ou D/16, ou D/17, ou D/18, ou D/19, ou D/20 d'un bord de la tranche ; et/ou
un ou plusieurs de la pluralité d'éléments de contact est positionné au moins à 50 mm, ou au moins à 60 mm, ou au moins à 70 mm, ou au moins à 75 mm, ou au moins à 80 mm, ou au moins à 90 mm, ou au moins à 100 mm, ou au moins à 110 mm, ou au moins à 120 mm, ou au moins à 130 mm, ou au moins à 140 mm du centre du support.

15. Appareil selon la revendication 5 ou 6, dans lequel le dispositif de pesage comprend un support pour supporter la tranche pendant la mesure de poids, dans lequel :
le support comprend une pluralité d'éléments de contact configurée pour être en contact avec une face inférieure de la tranche pour supporter la tranche pendant la mesure de poids ; et
la pluralité d'éléments de contact comprend deux longueurs différentes ou plus d'élément de contact,
facultativement, dans lequel :
la pluralité d'éléments de contact comprend deux longueurs différentes ou plus d'élément de contact pour supporter la tranche dans une orientation plus plane pendant la mesure de poids ; et/ou
au moins l'un de la pluralité d'éléments de contact a une longueur réglable.
